(19) Europäisches Patentamt European Patent Office Office européen des brevets

(11) **EP 4 711 914 A1**

(12) **EUROPEAN PATENT APPLICATION**

(43) Date of publication:
**18.03.2026 Bulletin 2026/12**

(21) Application number: **25200842.0**

(22) Date of filing: **08.09.2025**

(51) International Patent Classification (IPC):
**G06F 7/58** (2006.01) **G06N 5/01** (2023.01)

(52) Cooperative Patent Classification (CPC):
**G06F 7/58; G06N 5/01; G06N 5/022; G06N 7/01; G06N 20/00**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **13.09.2024 US 202463694480 P**

(71) Applicant: **Extropic Corp.**
**Austin TX 78757 (US)**

(72) Inventors:
• **Verdon-Akzam, Guillaume**
  **San Francisco, 94133 (US)**
• **Nahuel Freitas, Jose**
  **Cambridge, 02139 (US)**
• **Chamberland, Christopher Abraham**
  **Austin, 78748 (US)**
• **McCourt, Trevor Johnathan**
  **Cambridge, 02139 (US)**

(74) Representative: **Piotrowicz, Pawel Jan Andrzej et al**
**Venner Shipley LLP**
**406 Cambridge Science Park**
**Milton Road**
**Cambridge CB4 0WW (GB)**

(54) **CONFIGURING CIRCUITS FOR GENERATING SAMPLES ASSOCIATED WITH RANDOM WALKS ON A GRAPH**

(57) A method of configuring circuits for generating random walks on a graph comprising vertices interconnected by edges comprises: determining a number of colors associated with the graph, wherein each edge connected to a respective vertex is associated with a different respective color; arranging probabilistic circuit modules (PCMs), wherein each PCM comprises first and second inputs, first and second outputs, and is associated with an edge; arranging pluralities of input and output nodes; connecting each output of each PCM associated with a first color to an output node; connecting each input of each PCM associated with a second color to an input node; and connecting each output to a PCM input or to an output node such that the PCM outputs associated with a respective color are each connected to different respective PCM inputs associated with a different color or to an output node.

FIG. 1

EP 4 711 914 A1

**Description**

CROSS-REFERENCE TO RELATED APPLICATION(S)

This application claims priority to and the benefit of U.S. Provisional Application Serial No. 63/694,480, entitled "CONFIGURING CIRCUITS FOR GENERATING SAMPLES ASSOCIATED WITH RANDOM WALKS ON A GRAPH," filed September 13, 2024, the entire disclosure of which is incorporated herein by reference.

TECHNICAL FIELD

This disclosure relates to configuring circuits for generating samples associated with random walks on a graph.

BACKGROUND

Integrated circuits (ICs) comprising interconnected components including resistors, transistors, and capacitors, can be used to build electronic devices capable of performing complex operations. Some IC devices can be utilized to build electronic devices that are capable of performing computations. Compact designs coupled with advances in mass production capabilities and technologies have contributed to the widespread adoption of ICs. Current implementations of IC devices can utilize metal-oxide-semiconductor (MOS) integrated circuits that can be built on chip platforms comprising silicon. Some IC devices can be built with complementary metal-oxide-semiconductors (CMOS) comprising semiconductors doped with elements to modify their associated physical properties.

SUMMARY

In one aspect, in general, an apparatus for generating random walks on a graph comprising a plurality of vertices interconnected by a plurality of edges such that each vertex of the plurality of vertices is connected to one or more other vertices of the plurality of vertices by different respective edges of the plurality of edges comprises: a circuit module comprising a plurality of input nodes where each input node of the plurality of input nodes is associated with a respective voltage input value such that the plurality of input nodes is associated with a vector of voltage input values, a plurality of output nodes where each output node of the plurality of output nodes is associated with a respective voltage output value such that the plurality of output nodes is associated with a vector of voltage output values, and mapping circuitry defining a different respective mapping from each input node of the plurality of input nodes to a respective output node of the plurality of output nodes; and error detection circuitry connected to each output node of the plurality of output nodes; wherein each vertex of the plurality of vertices of the graph is associated with a different respective input node of the plurality of input nodes and the respective voltage input value in the vector of voltage input values by a respective index and each vertex of the plurality of vertices of the graph is associated with a different respective output node of the plurality of output nodes and a voltage output value in the vector of output voltage values by a respective index; wherein each edge of the plurality of edges of the graph is associated with a different respective mapping defined by the mapping circuitry; wherein the circuit module is configured to receive the vector of voltage input values where one voltage input value in the vector of voltage input values is a first voltage value having a first index with respect to one input node of the plurality of input nodes, and each other voltage input value in the vector of voltage input values is a second voltage value different from the first voltage value; wherein the circuit module is configured to produce, based at least in part on the vector of voltage input values and the mapping circuitry, the vector of voltage output values where one voltage output value in the vector of voltage output values is the first voltage value having a second index with respect to one output node in the plurality of output nodes; and wherein the error detection circuitry is configured to confirm that one voltage output value in the vector of voltage output values is the first voltage value and each other voltage output value in the vector of voltage output values is the second voltage value.

Aspects can include one or more of the following features.

Upon confirming that one voltage output value in the vector of voltage output values is the first voltage value and each other voltage output value in the vector of voltage output values is the second voltage value, the error detection circuitry is configured to send the vector of voltage output values to the plurality of input nodes.

The mapping circuitry comprises a plurality of probabilistic circuit modules, each probabilistic circuit module of the plurality of probabilistic circuit modules comprising a first input, a second input, a first output, and a second output, wherein each probabilistic circuit module of the plurality of probabilistic circuit modules is associated with a different respective edge of the plurality of edges of the graph and each of the first input and the second input and each of the first output and the second output of a respective probabilistic circuit module of the plurality of probabilistic circuit modules associated with a particular edge of the plurality of edges is associated with a different respective vertex of the plurality of vertices of the graph connected to the particular edge of the plurality of edges, wherein each probabilistic circuit module input associated with a respective vertex of the plurality of vertices of the graph is connected to a respective input node of the plurality of input nodes associated with the respective vertex of the plurality of vertices of the graph or to a probabilistic circuit module output associated with the respective vertex of the plurality of vertices of the graph, and wherein each probabilistic circuit module output associated with a respective vertex of the plurality of vertices of the graph is connected to a respective output node of the plurality of output nodes associated with the respective vertex of the plurality of vertices of the graph or to a probabilistic circuit module input associated with the respective vertex of the plurality of vertices of the graph.

Each probabilistic circuit module of plurality of probabilistic circuit modules further comprises a third input and a first metastable circuit module configured to receive a bias voltage from the third input and produce, based at least in part on the bias voltage, a first bistable state that varies over time between a first stable voltage and a second stable voltage, where a fraction of time that the first bistable state spends at the first stable voltage is associated with a first probability.

Each probabilistic circuit module of the plurality of probabilistic circuit modules further comprises a level-shifter circuit configured to add a voltage to or subtract a voltage from a signal based at least in part on the first stable voltage and a signal based at least in part on the second stable voltage.

One or more probabilistic circuit modules of the plurality of probabilistic circuit modules further comprises a first logical circuit, a second logical circuit, a third logical circuit, wherein the first logical circuit is configured to receive a signal based at least in part on the first bistable state and a voltage from the first input and output a logical combination of the signal based at least in part on the first bistable state and the voltage from the first input to the third logical circuit, the second logical circuit is configured to receive a signal based at least in part on the first bistable state and a voltage from the first input and output a logical combination of the signal based at least in part on the first bistable state and the voltage from the first input to the second output, and the third logical circuit is configured to receive a voltage from the second input and output a logical combination of the logical combination received from the first logical circuit and the voltage from the second input to the first output.

Each of the first logical circuit and the second logical circuit comprise respective AND gates and the third logical circuit comprises an OR gate.

One or more probabilistic circuit modules of the plurality of probabilistic circuit modules further comprises a first logical circuit module, a second logical circuit module, a first logical circuit, and a second logical circuit, wherein the first logical circuit module is configured to receive a signal based at least in part on the first bistable state and a voltage from first input and output a logical combination of the signal based at least in part on the first bistable state and the voltage from the first input to each of the first logical circuit and the second logical circuit, the second logical circuit module is configured to receive a signal based at least in part on the first bistable state and a voltage from the second input and output a logical combination of the signal based at least in part on the first bistable state and the voltage from the second input to each of the first logical circuit and the second logical circuit, the first logical circuit is configured to output a logical combination from the first logical circuit module and the second logical circuit module to the first output, and the second logical circuit is configured to output a logical combination from the first logical circuit module and the second logical circuit module to the second output.

Each of the first logical circuit and the second logical circuit comprise respective OR gates, and each of the first logical circuit module and the second logical circuit module comprise a respective first AND gate, a second AND gate, and an inverter.

One or more probabilistic circuit modules of the plurality of probabilistic circuit modules further comprises a fourth input and a second metastable circuit module configured to receive a bias voltage from the fourth input and produce, based at least in part on the bias voltage, a second bistable state that varies over time between a third stable voltage and a fourth stable voltage, where a fraction of time that the second bistable state spends at the third stable voltage is associated with a second probability.

The one or more probabilistic circuit modules further comprises a first level-shifter circuit and a second level-shifter circuit wherein the first level-shifter circuit is configured to shift a signal based at least in part on the first bistable state produced by the first metastable circuit module and the second level-shifter circuit is configured to shift a signal based at least in part on the second bistable state produced by the second metastable circuit module.

The first level-shifter circuit is configured to add a reference voltage to or subtract a reference voltage from each of the first stable voltage and the second stable voltage and the second level-shifter circuit is configured to add a reference voltage to or subtract a reference voltage from each of the third stable voltage and the fourth stable voltage.

The first stable voltage and the third stable voltage of each probabilistic circuit module of the plurality of probabilistic circuit modules are equal, and the second stable voltage and the fourth stable voltage of each probabilistic circuit module of the plurality of probabilistic circuit modules are equal.

The one or more probabilistic circuit modules of the plurality of probabilistic circuit modules further comprise a first logical circuit, a second logical circuit, a third logical circuit, a fourth logical circuit, a fifth logical circuit, and a sixth logical circuit, wherein the first logical circuit is configured to receive a signal based at least in part on the first bistable state and a voltage from the first input and produce a logical combination of the signal based at least in part on the first bistable state and the voltage from the first input to the fifth logical circuit, the second logical circuit is configured to receive a signal based at least in part on the first bistable state and a voltage from the first input and produce a logical combination of the signal based at least in part on the first bistable state and the voltage from the first input to the sixth logical circuit, the third logical circuit is configured to receive a signal based at least in part on the second bistable state and a voltage from the second input and produce a logical combination of the signal based at least in part on the second bistable state and the voltage from the second input to the fifth logical circuit, the fourth logical circuit is configured to receive a signal based at least in part on the second bistable state and a voltage from the second input and produce a logical combination of the signal based at least in part on the second bistable state and the voltage from the second input to the sixth logical circuit, the fifth logical circuit is configured to produce a logical combination of the logical combination received from the first logical circuit and the logical combination received from the third logical circuit to the first output, and the sixth logical circuit is configured to produce a logical combination of the logical combination received from the second logical circuit and the logical combination received from the fourth logical circuit to the second output.

Each of the first logical circuit, the second logical circuit, the third logical circuit, and the fourth logical circuit comprise a respective AND gate, and each of the fifth logical circuit and the sixth logical circuit comprise a respective OR gate.

In another aspect, in general, a method of configuring circuits for generating random walks on a graph comprising a plurality of vertices interconnected by a plurality of edges such that each vertex of the plurality of vertices is connected to one or more other vertices of the plurality of vertices by different respective edges of the plurality of edges comprises: determining a number of colors associated with the graph, wherein each vertex of the plurality of vertices is connected to respective edges of the plurality of edges such that the respective edges of the plurality of edges are each associated with a different respective color; arranging a plurality of probabilistic circuit modules, wherein each probabilistic circuit module of the plurality of probabilistic circuit modules comprises a first input, a second input, a first output, and a second output, and each probabilistic circuit module of the plurality of probabilistic circuit modules is associated with a different respective edge of the plurality of edges; arranging a plurality of input nodes and a plurality of output nodes; connecting each output of each probabilistic circuit module of the plurality of probabilistic circuit modules that is associated with a first color to a different respective output node of the plurality of output nodes; connecting each input of each probabilistic circuit module of the plurality of probabilistic circuit modules that is associated with a second color to a different respective input node of the plurality of input nodes; and connecting each output of each probabilistic circuit module of the plurality of probabilistic circuit modules to a different respective input of a different probabilistic circuit module of the plurality of probabilistic circuit modules or to a different respective output node of the plurality of output nodes such that the outputs of each probabilistic circuit module of the plurality of probabilistic circuit modules associated with a respective color are each connected to different respective inputs of each probabilistic circuit module of the plurality of probabilistic circuit modules associated with a different color or to an output node of the plurality of output nodes.

Aspects can include one or more of the following features.

Each probabilistic circuit module of plurality of probabilistic circuit modules further comprises a third input and a first metastable circuit module, where the first metastable circuit module is configured to receive a bias voltage from the third input and produce, based at least in part on the bias voltage, a first bistable state that varies over time between a first stable voltage and a second stable voltage, where a fraction of time that the first bistable state spends at the first stable voltage is associated with a first probability.

Each input node of the plurality of input nodes is associated with a respective voltage input value such that the plurality of input nodes is associated with a vector of voltage input values where one voltage input value in the vector of voltage input values is a first voltage value having a first index with respect to one input node of the plurality of input nodes, and each other voltage input value in the vector of voltage input values is a second voltage value different from the first voltage value.

Each output node of the plurality of output nodes is associated with a respective voltage output value such that the plurality of output nodes is associated with a vector of voltage output values where one voltage output value having a second index with respect to one output node of the plurality of output nodes is the first voltage value.

Each output node of the plurality of output nodes and each input node of the plurality of input nodes is connected to error detection circuitry.

The error detection circuitry is configured to check that one voltage output value in the vector of voltage output values is the first voltage value and each other voltage output value in the vector of voltage output values is the second voltage value.

Aspects can have one or more of the following advantages.

Some implementations of circuits disclosed herein can be utilized to generate random walks on arbitrary graphs. In some implementations, generating random walks using circuits can be faster and more energy efficient than generating random walks via other implementations.

Other features and advantages will become apparent from the following description, and from the figures and claims.

BRIEF DESCRIPTION OF THE DRAWINGS

The disclosure is best understood from the following detailed description when read in conjunction with the accompanying drawing. It is emphasized that, according to common practice, the various features of the drawing are not to-scale. On the contrary, the dimensions of the various features are arbitrarily expanded or reduced for clarity. The plots resulting from numerical simulations, as indicated below, are working examples of experimental results associated with some of the techniques described herein, and the other plots are prophetic examples of predicted experimental results.

FIG. **1** is a schematic diagram of an example circuit module configured to receive a one-hot vector and produce a one-hot vector.

FIG. **2A** is a schematic diagram of an example graph comprising vertices and edges.

FIG. **2B** is a schematic diagram of an example circuit module.

FIG. **2C** is a schematic diagram of an example graph with transition probabilities.

FIGS. **2D-2G** are schematic diagrams of example CMOS transistors.

FIGS. **3A-3C** are schematic diagrams of example metastable circuits.

FIG. **3D** is a plot of numerical simulations associated with a metastable circuit.

FIGS. **4A-4B** are schematic diagrams of example demultiplexer circuits.

FIGS. **5A-5C** are schematic diagrams of example circuits.

FIGS. **6A-6D** are schematic diagrams of example probabilistic circuit modules.

FIG. **7** is a schematic diagram of an example logical circuit.

FIG. **8A** is a schematic diagram of an example circuit module.

FIG. **8B** is a schematic diagram of an example circuit.

FIG. **8C** is a schematic diagram of an example timing protocol.

FIGS. **9A-9B** are schematic diagrams of example graphs comprising vertices and edges.

FIG. **9C** is a schematic diagram of an example circuit module.

FIG. **10** is a flowchart of an example method of configuring circuits.

DETAILED DESCRIPTION

Some integrated circuits can be operated in regime wherein fundamental thermodynamic processes characterize their behavior. In some examples, this operation can comprise driving a transistor in an integrated circuit using a voltage that is below a threshold voltage associated with the transistor such that the transistor is operating in the "sub-threshold regime" or below the sub-threshold limit. By way of example, some transistors operating in the sub-threshold regime can be driven at voltages between 0 mV and 175 mV. Some electronic devices comprising these transistors can harness thermodynamic processes to perform operations or computations.

Some circuits can comprise n-type metal-oxide-semiconductor (nMOS) or p-type metal-oxide-semiconductor (pMOS) transistors. nMOS transistors comprise semiconductors doped with an electron donor element, such as phosphorus, arsenic or antimony. pMOS transistors comprise semiconductors doped with an electron acceptor element such as boron, aluminum, or gallium.

Some metal-oxide-semiconductor (MOS) or complementary metal-oxide-semiconductor (CMOS)-based circuits can be configured such that the circuits are capable of generating random walks of a graph. Some graphs comprise a plurality of vertices connected by a plurality of edges. A random walk on such a graph can create a path through the graph comprising a plurality of steps, where each step comprises traveling from a first vertex to a second vertex along a respective edge. In some implementations, each step can be probabilistic such that traveling along a given edge occurs according to a corresponding probability and remaining in place at the first vertex occurs according to corresponding probability, where the probabilities of all possible next steps from a given vertex sum to one.

In some implementations, a circuit, i.e., an apparatus, can be configured to generate random walks of a graph represented by voltages encoded in a one-hot encoded binary vector. A one-hot encoded binary vector is a vector of length *N* comprising a *N* bits wherein one bit has a value of "1" while the other bits have a value of "0." An example of a one-hot encoded binary vector comprising 6 bits is: [010000]. In some one-hot encoded binary vectors, the bit represented by a "1" can correspond to a high voltage value while each other bit represented by a "0" can correspond to a complementary voltage value.

In some implementations, the one-hot encoded binary vector can correspond to the state of vertices of an arbitrary graph *G* comprising a plurality of vertices interconnected by a plurality of edges such that a CMOS-based circuit can generate random walks on the graph *G*. In such implementations, each input voltage encoded in the one-hot encoded binary vector can correspond to a different respective vertex in the arbitrary graph *G*. The edges of the graph describe allowed transitions of the bit in the state "1" between bits incident to the edge, where the vertices of the graph are used to encode the state of the input bits.

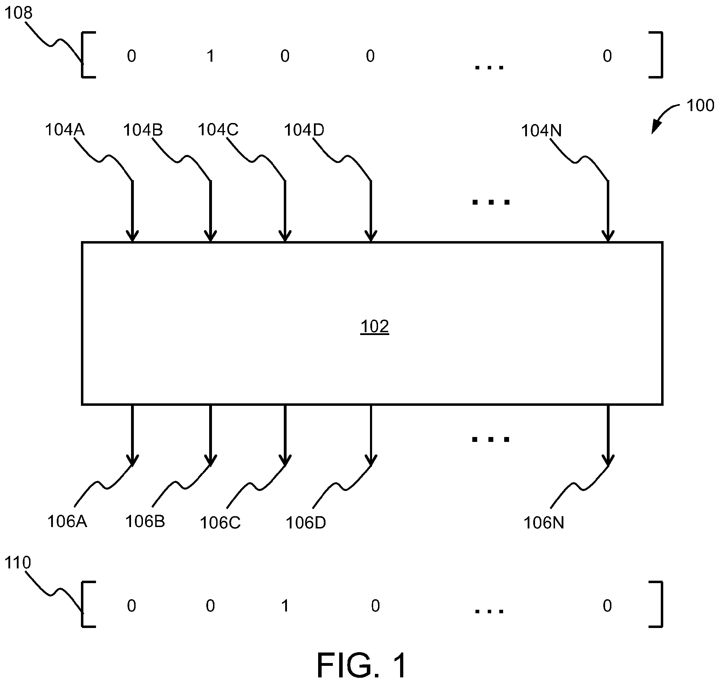

An example circuit 100 that can implement a random walk of an input vector with a one-hot encoding is shown in FIG. 1. In some implementations, the circuit 100 can be referred to as a p-block circuit. The circuit 100 comprises a circuit module 102 that comprises a plurality of input nodes 104A-104N, i.e., an input node 104A, an input node 104B, an input node 104C, an input node 104D, and an input node 104N, where each input node of the plurality of input nodes 104A-104N is associated with a respective voltage input value such that the plurality of input nodes 104A-104N is associated with a vector of voltage input values 108. The circuit module 102 comprises a plurality of output nodes 106A-106N, i.e., an output node 106A, an output node 106B, an output node 106C, an output node 106D, and an output node 106N, where each output node of the plurality of output nodes 106A-106N is associated with a respective voltage output value such that the plurality of output nodes 106A-106N is associated with a vector of voltage output values 110. The circuit module 102 is configured to receive a vector of voltage input values 108 where one voltage input value in the vector of voltage input values 108 is a first voltage value, i.e., 1, having a first index, and each other voltage input value in the vector of voltage input values 108 is a second voltage value, i.e., 0. The circuit module 102 is configured to produce, based at least in part on the received vector of voltage input values 108, a vector of voltage output values 110 where one voltage output value in the vector of voltage output values 110 is the first voltage value, i.e., 1, having a second index, and each other voltage output value in the vector of voltage output values 110 is the second voltage value, i.e., 0. In some examples, the first index and the second index can be the same or different.

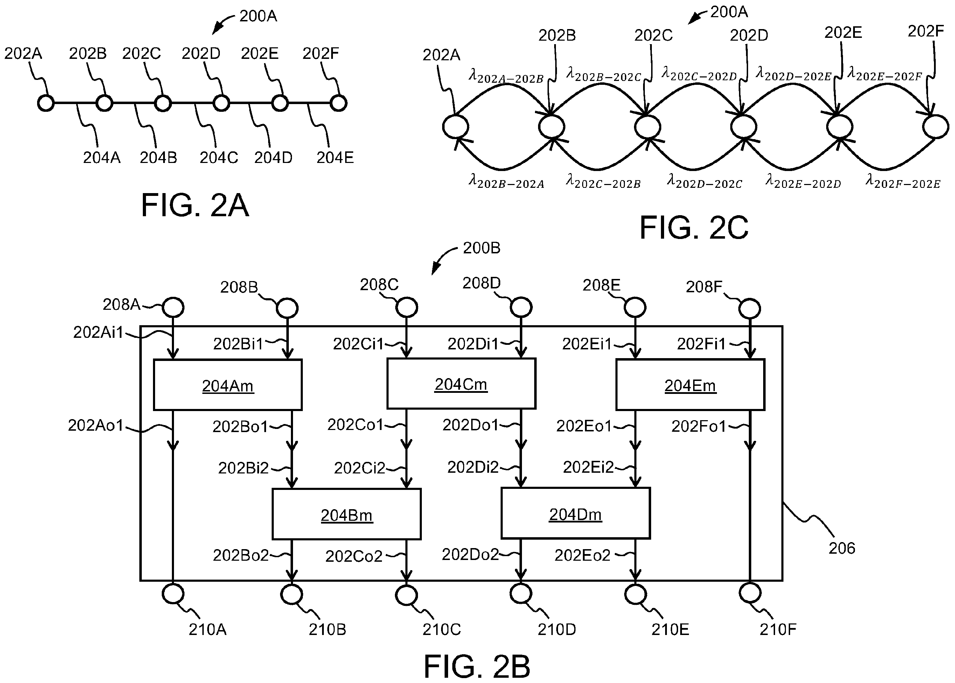

Some circuits can generate random walks on a graph comprising a plurality of vertices interconnected by a plurality of edges such that each vertex is connected to each of one or more other vertices by different respective edges. An example graph 200A comprising a plurality of vertices 202A-202F, i.e., a vertex 202A, a vertex 202B, a vertex 202C, a vertex 202D, a vertex 202E, and a vertex 202F, interconnected by a plurality of edges 204A-204E, i.e., an edge 204A, an edge 204B, an edge 204C, an edge 204D, and an edge 204E, is shown in FIG. 2A. In some examples, the graph 200A can be referred to as a one-dimensional graph. An example circuit 200B that is configured to generate random walks on the graph 200A is shown in FIG. 2B. The circuit 200B comprises a circuit module 206. The circuit module 206 comprises a plurality of input nodes 208A-208F, i.e., an input node 208A, an input node 208B, an input node 208C, an input node 208D, an input node 208E, and an input node 208F, and a plurality of output nodes 210A-210F, i.e., an output node 210A, an output node 210B, an output node 210C, an output node 210D, an output node 210E, and an output node 210F. Each vertex of the plurality of vertices 202A-202F of the graph 200A is associated with a different respective input node of the plurality of input nodes 208A-208F and a different respective output node of the plurality of output nodes 210A-210F. The circuit module 206 also comprises mapping circuitry defining different respective mapping from each input node of the plurality of input nodes 208A-208F to a different respective output node of the plurality of output nodes 210A-210F. The mapping circuitry comprises a plurality of probabilistic circuit modules 204Am-204Em arranged according to the plurality of mappings. Each probabilistic circuit module of the plurality of probabilistic circuit modules 204Am-204Em is associated with a different respective edge of the plurality of edges 204A-204E of the graph 200A. Each probabilistic circuit module of the plurality of probabilistic circuit modules 204Am-204Em comprises two inputs and two outputs, where an input and an output are associated with a vertex of the plurality of vertices 202A-202F and the other input and the other output are associated with a different vertex of the plurality of vertices 202A-202F. The inputs are labeled 202Xij, where each X represents the letter of the vertex of the plurality of vertices 202A-202F with which the input is associated and j is a count of the number of associated inputs. The outputs of the probabilistic circuit modules of the plurality of probabilistic circuit modules 204Am-204Em are labeled 202Xok, where each X represents the letter of the vertex of the plurality of vertices 202A-202F with which the output is associated and k is a count of the number of associated outputs. Because each probabilistic circuit module of the plurality of probabilistic circuit modules 204Am-204Em is associated with a respective edge of the plurality of edges 204A-204E, each of the inputs 202Xij and outputs 202Xok correspond to the respective vertices of the plurality of vertices 202A-202F connected to the respective edge of the plurality of edges 204A-204E. For instance, the edge 204C is connected to a vertex 202C and a vertex 202D. The probabilistic circuit module 204Cm has an input 202Ci1 and an output 202Co1 associated with vertex 202C. The probabilistic circuit module 204Cm also has an input 202Di1 and an output 202Do1 associated with vertex 202D.

Each input 202Xij associated with a respective vertex of the plurality of vertices 202A-202F is connected to a respective input node of the plurality of input nodes 208A-208F associated with the respective vertex of the plurality of vertices 202A-202F or to an output 202Xok associated with the respective vertex of the plurality of vertices 202A-202F. Each output 202Xok associated with the respective vertex of the plurality of vertices 202A-202F is connected to a respective output node of the plurality of output nodes 210A-210F associated with the respective vertex of the plurality of vertices 202A-202F or to an input 202Xij associated with the respective vertex of the plurality of vertices 202A-202F. For instance, the input node 208C is connected to input 202Ci1, the output 202Co1 is connected to input 202Ci2, and the output 202Co2 is connected to the output node 210C. The plurality of probabilistic circuit modules 204Am-204Em are arranged in two layers such that the probabilistic circuit modules of the plurality of probabilistic circuit modules 204Am-204Em in a given layer can be implemented in parallel. For the circuit 200B, the probabilistic circuit module 204Am, the probabilistic circuit module 204Cm, and the probabilistic circuit module 204Em form a first layer. The probabilistic circuit module 204Bm and the probabilistic circuit module 204Dm form a second layer. The layers are chosen to allow the bit corresponding to a 1 to hop to any of the adjacent bits corresponding to a 0.

Each input node of the plurality of input nodes 208A-208F is associated with a respective voltage input value such that the plurality of input nodes 208A-208F is associated with a vector of voltage input values. Each output node of the plurality of output nodes 210A-210F is associated with a respective voltage output value such that the plurality of output nodes 210A-210F is associated with a vector of voltage output values. Each vertex of the plurality of vertices 202A-202F of the graph 200A is associated with a different respective voltage input value in the vector of voltage input values by a respective index and a different respective voltage output value in the vector of output voltage values by a respective index. In some examples, the vector of voltage input values and the vector of voltage output values can each be a one-hot binary vector. The circuit 200B is configured to receive a respective voltage in a one-hot binary vector at each input node of the plurality of input nodes 208A-208F and produce, based at least in part on the received one-hot binary vector and the plurality of mappings, a respective voltage at each output node of the plurality of output nodes 210A-210F such that the output is a one-hot binary vector.

The plurality of probabilistic circuit modules 204Am-204Em is configured such that the one-hot bit in the one-hot binary vector can hop to an adjacent bit in the one-hot binary vector, which is equivalent to a random walk along an edge of the plurality of edges 204A-204E of the graph 200A. In some implementations, each probabilistic circuit module of the plurality of probabilistic circuit modules 204Am-204Em can be configured to receive a bias voltage that can tune a probability associated with a hopping along an edge. FIG. 2C depicts the example graph 200A comprising the plurality of vertices 202A-202F and forwards/backwards transition rates $\lambda_{202i\text{-}202j}$ that correspond to a probability per unit time that the one-hot bit "hops" between a vertex i and a vertex j of the graph 200A. In some examples, the output vector of the circuit 200B can be used as a new input vector to the circuit 200B and this process can be iterated to generate a random walk between neighboring vertices. By applying multiple iterations of the circuit and choosing appropriate transition rates, the output vector can be sampled from a steady-state distribution.

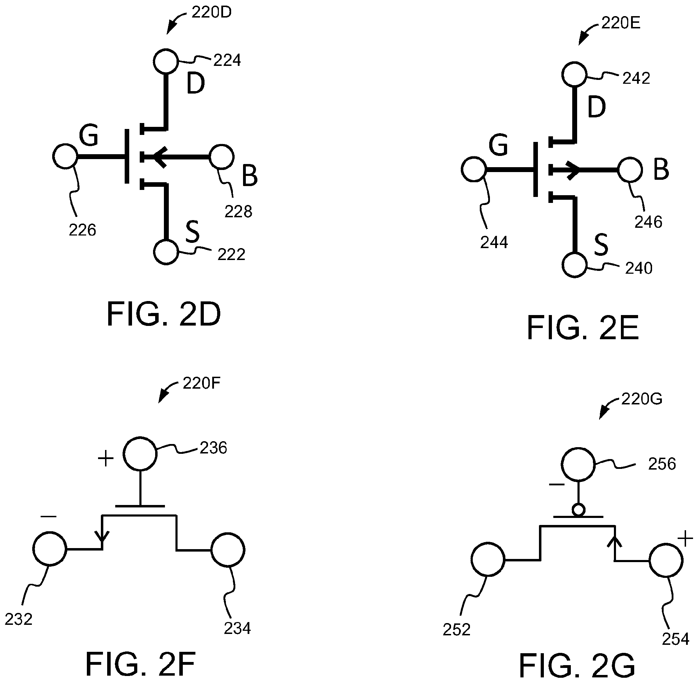

Some probabilistic circuit modules can comprise p-type metal-oxide-semiconductor (pMOS) or n-type metal-oxide-semiconductor (nMOS) transistors. FIGS. 2D-2G depict example pMOS and nMOS transistors. FIG. 2D depicts an nMOS transistor 220D comprising a source terminal 222 associated with a voltage $V_S$, a drain terminal 224 associated with a voltage $V_D$, a gate terminal 226 associated with a voltage $V_g$, and a body terminal 228. Some nMOS transistors can comprise three terminals rather than four terminals. An example nMOS transistor 220F comprising three terminals is depicted in FIG. 2F. The nMOS transistor 220F comprises a source terminal 232 associated with a voltage $V_S$, a drain terminal 234 associated with a voltage $V_D$, and a gate terminal 236 associated with a voltage $V_g$. nMOS transistors typically have positive threshold voltages $V_{th}$. An nMOS transistor can act as a short, or conduct, when $V_g - V_S > V_{th}$ and act as open circuits when $V_g - V_S < V_{th}$. nMOS transistors can have $V_D > V_S$ and can source current to the load. The voltage $V_S$ associated with the source terminal 222 or the source terminal 232 can be low (near or at ground) to ensure the above conditions can easily be satisfied.

FIG. 2E depicts a pMOS transistor 220E comprising a source terminal 240 associated with a voltage $V_S$, a drain terminal 242 associated with a voltage $V_D$, a gate terminal 244 associated with a voltage $V_g$, and a body terminal 246. Some pMOS transistors can comprise three terminals rather than four terminals. An example pMOS transistor 220G comprising three terminals is depicted in FIG. 2G. The pMOS transistor 220G comprises a source terminal 252 associated with a voltage $V_S$, a drain terminal 254 associated with a voltage $V_D$, a gate terminal 256 associated with a voltage $V_g$. pMOS transistors typically have negative threshold voltages (i.e. $V_{th} < 0$). A pMOS transistor can act as a short, or conduct, when $V_g - V_S < -|V_{th}|$ and act as an open circuit when $V_g - V_S > -|V_{th}|$. For pMOS transistors, $V_S$ can be large to ensure that $V_g - V_S$ conditions can more easily be satisfied. In addition, pMOS transistors can have $V_D < V_S$ such that current is sunk from the load to the source. By tuning the source and gate voltages of nMOS and pMOS transistors, a circuit can thus act as a short or open circuit.

In some implementations if $V_g < V_{th}$ and $V_S \neq V_D$, some small amount of current, known as leakage current, can flow between the source terminal and the drain terminal. Because $V_g < V_{th}$, this operating regime can be referred to as "subthreshold" and the behavior of the transistor can be characterized by thermodynamic processes.

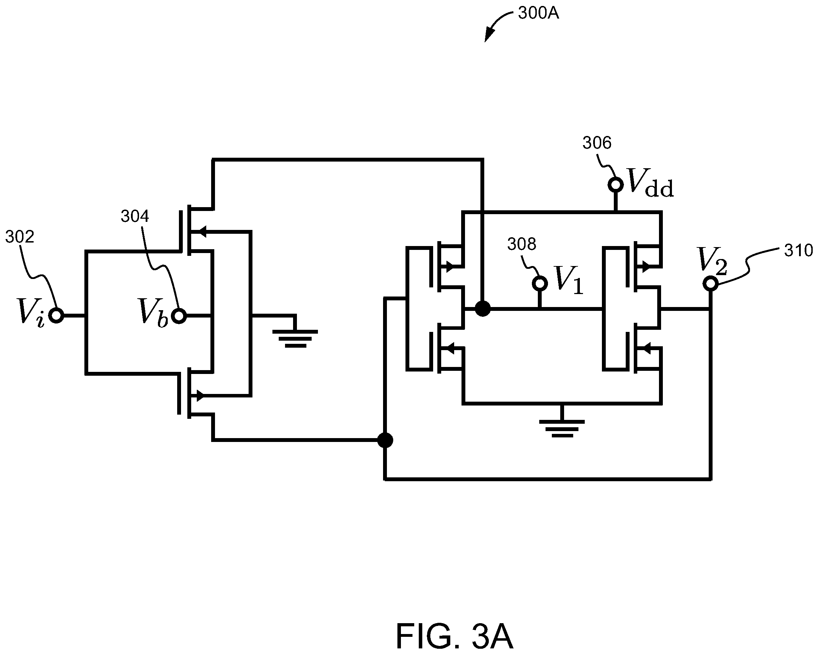

In some implementations, the probabilistic circuit modules can be configured such that an applied bias can be utilized to tune a probability associated with a hopping process. In other words, tuning the applied biases can result in tunable transition rates associated with the forwards and backwards hopping processes. Some probabilistic circuit modules can comprise one or more metastable circuits configured to receive an applied bias. Some metastable circuits can be a probability bit circuit, also known as a p-bit. An example circuit 300A that can be used as a p-bit is shown in FIG. 3A. The circuit 300A comprises several nMOS and pMOS transistors and a terminal 302, a terminal 304, a terminal 306, a terminal 308, and a terminal 310 each associated with respective voltages $V_i$, $V_b$, $V_{dd}$, $V_1$, and $V_2$. For fixed voltages $V_{dd}$, $V_b$ and $V_i$, the state of the p-bit at the terminal 308 and the terminal 310 comprises the output voltages $\boldsymbol{V} = (V_1, V_2)$. The p-bit is a bistable circuit with two metastable states $\boldsymbol{V}_x \simeq (0, V_{dd})$ and $\boldsymbol{V}_y \simeq (V_{dd}, 0)$. At steady state, the p-bit can be in the metastable state $\boldsymbol{V}_x$ with probability $p$, or in the metastable state $\boldsymbol{V}_y$ with probability $1 - p$. In other words, the bistable state varies over time between a first stable voltage and a second stable voltage, where a fraction of time that the first bistable state spends at the first stable voltage is associated with a first probability and a fraction of time that the first bistable state spends at the second stable voltage is associated with a second probability. These transitions can be driven by thermal fluctuations of charges throughout the circuit. The particular value of $p$ is controlled by the input voltage $V_i$. When $V_i$ approaches $V_{dd}$, $p$ tends to 1, and when $V_i$ approaches 0, $p$ tends to 0. The precise relationship between $p$ and $V_i$ can be tuned by the biasing voltage $V_b$. In other words, a bias b applied to a p-bit can bias a probability distribution at the output of the p-bit.

In the circuit 300A, bistable behavior is generated by the right-hand portion of the circuit, which consists of two-coupled NOT gates as in some static random-access memory (SRAM) cells. In some bistable circuits, a powering voltage $V_{dd}$ can be above a critical value $V_{dd}^*$, which for the case in which all transistors have exactly the same parameters and the subthreshold slope is $n = 1$ takes the value $V_{dd}^* = V_T \ln 2$, where $V_T = k_b T/q_e$ is the thermal voltage.

In some examples, random transitions between two metastable nonequilibrium steady states can occur with a transition rate that depends on the power voltage $V_{dd}$. In some examples, frequent random transitions can be expected whenever the standard deviation of the fluctuations around the output voltage $\sigma_V = \sqrt{k_b T/C}$ is comparable to the mean value $\langle V_1 - V_2 \rangle \approx \pm V_{dd}$. In this equation, $C$ is the typical capacitance value at the output nodes. Hence, these transitions can be controlled by changing the powering voltage $V_{dd}$. Alternatively, for fixed $V_{dd} > V_{dd}^*$, the transitions can be changed by the temperature or size of the transistors, since the size of a transistor can affect the typical capacitance $C$.

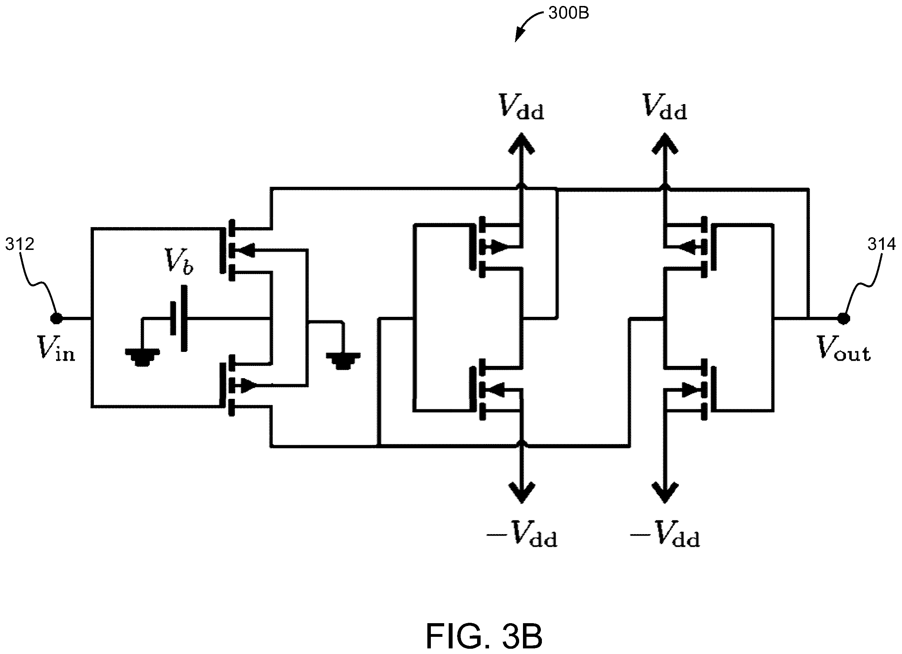

The circuit 300A comprises two outputs. Some p-bits can comprise one output. FIG. 3B depicts an example circuit 300B that can be used as a p-bit. The circuit 300B comprises pMOS and nMOS transistors, an input terminal 312 associated with a voltage $V_{in}$, an output terminal 314 associated with a voltage $V_{out}$, and terminals associated with voltages $V_{dd}$. The circuit 300B is configured to receive a bias voltage $V_b$. At steady state, the output terminal 314 can be in the metastable state $V_{out} = V_{dd}$ with probability $p$, or in the metastable state $V_{out} = -V_{dd}$ with probability $1 - p$.

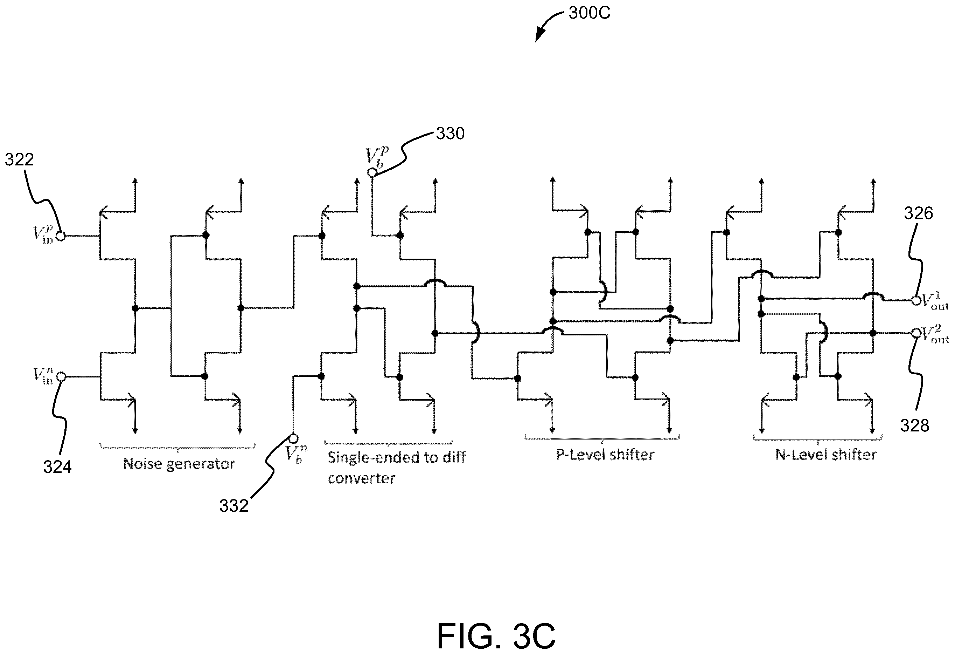

An example circuit 300C that can be used as a p-bit is shown in FIG. 3C. The circuit 300C comprises a first input 322, a second input 324, a first output 326, and a second output 328. The first input 322 is associated with a voltage $V_{in}^p$, the second input 324 is associated with a voltage $V_{in}^n$ the first output 326 is associated with a voltage $V_{out}^1$, and the second output 328 is associated with a voltage $V_{out}^2$. The circuit 300C also has a bias 330 associated with a voltage $V_b^p$ and a bias 332 associated with a voltage $V_b^n$ that can be used to control the first output 326 and the second output 328. The bias 330 and the bias 332 can be used to address variations in transistor parameters that can occur during the fabrication process. The component of the circuit 300C labeled "Single-ended to diff converter" can take the noise generated from the first module and outputs two noisy signals that can be anticorrelated. The circuit 300C also comprises a P-level shifter that can shift voltages upwards and a N-level shifter that can shift voltages downwards.

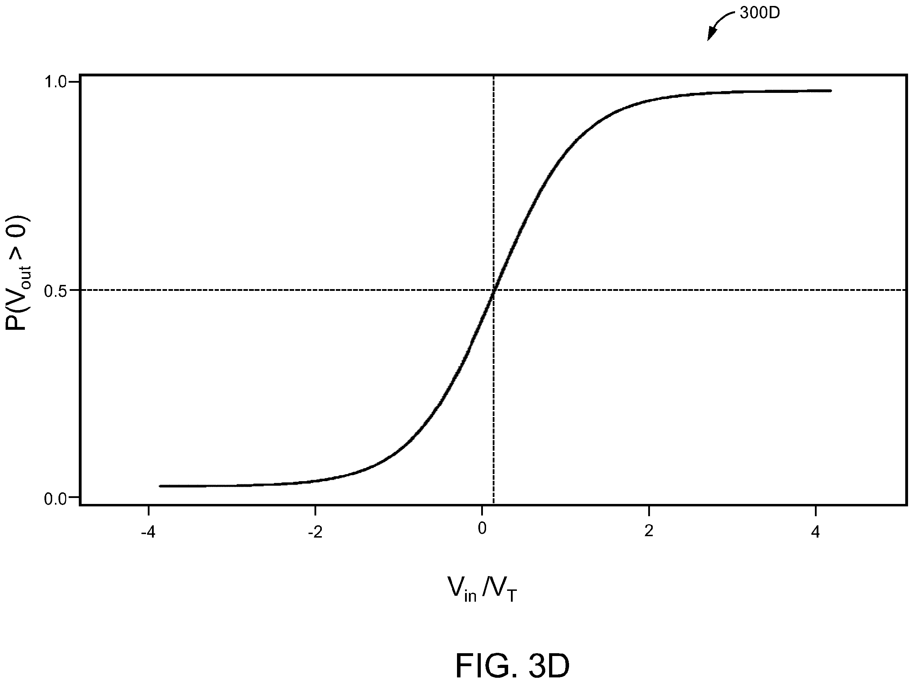

As previously mentioned, in some implementations a bias b applied to a p-bit can bias a probability distribution at the output of the p-bit. A plot 300D of a probability $p = P(Vout > 0)$ as a function of the voltage $V_i/V_T$ associated with an example p-bit is shown in FIG. 3D. As shown in the plot 300D, $P(Vout > 0)$ is linear in some range and behaves as a sigmoid function over the full range of $V_i$. The particular range for the linear regime can be tuned based on the circuit parameters of a p-bit. In some examples, if the obtained range is not large enough, a p-bit circuit can be constructed out of multiple p-bit circuits, each having their own range for the linear regime, therefore increasing the effective range of the *p*-bit.

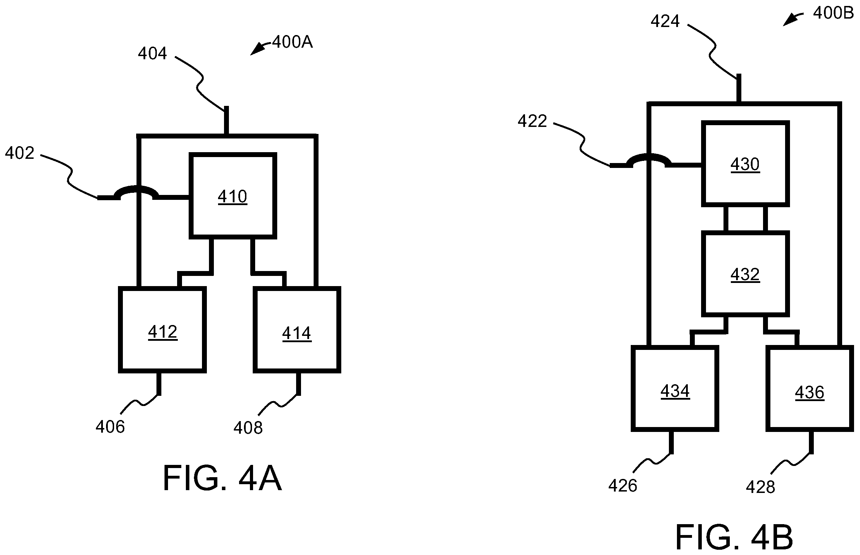

Some probabilistic circuit modules can comprise one or more circuits configured as a demultiplexer circuit. FIG. 4A depicts an example circuit 400A that can be used as a demultiplexer circuit. The circuit 400A comprises a first input node 402, a second input node 404, a first output node 406 and a second output node 408. The circuit 400A comprises a circuit 410. The two outputs of circuit 410 are each directed to a logical circuit 412 and logical circuit 414, respectively. The logical circuit 412 and the logical circuit 414 are each configured to receive the outputs from the circuit 410 and output, to the first output node 406 and second output node 408, respectively, a logical combination of the outputs from the circuit 410 with a voltage from the second input node 404.

In some examples, the circuit 400A can be configured such that the logical circuit 412 and the logical circuit 414 are each AND gates and the circuit 410 is an inverter. In such an implementation, the circuit 400A can be referred to as a "demux circuit." In some implementations, the circuit 400A can be configured such that the logical circuit 412 and the logical circuit 414 are each AND gates and the circuit 410 is a metastable circuit such as the circuit 300A shown in FIG. 3A or the circuit 300C shown in FIG. 3C. Such implementations can be referred to as a "pdemux circuit."

Some demultiplexer circuits can comprise a level-shifter circuit that is configured to translate input voltages from a metastable circuit. In some examples, a level-shifter circuit can be configured to add a reference voltage to or subtract a reference voltage from an input voltage.

FIG. 4B depicts an example circuit 400B that can be used as a demultiplexer circuit. The circuit 400B comprises a first input node 422, a second input node 424, a first output node 426 and a second output node 428. The circuit 400B comprises a metastable circuit 430 that receives a bias voltage from the first input node 422. The two outputs of metastable circuit 430 are each directed a level-shifter circuit 432. In other words, the level-shifter circuit 432 receives and can shift signals based at least in part on the bistable state produced by the metastable circuit, i.e., stable voltages. The logical circuit 434 and the logical circuit 436 are each configured to receive the outputs from the level-shifter circuit 432 and output, to the first output node 426 and second output node 428, respectively, a logical combination of the outputs from the level-shifter circuit 432 with a voltage from the second input node 424.

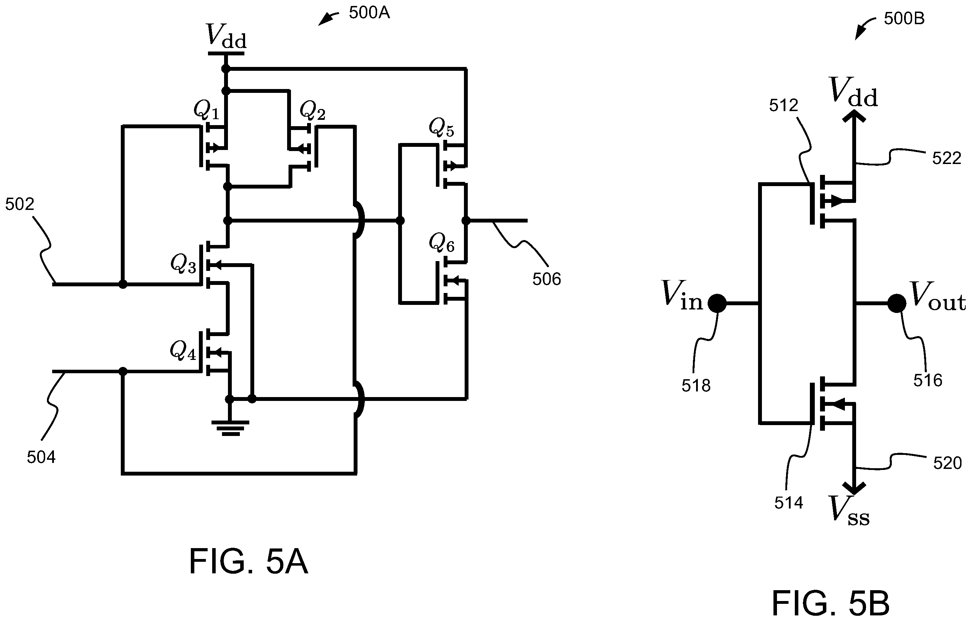

An example CMOS implementation of an AND gate 500A that can be used as the logical circuit 412 and the logical circuit 414 in a demux circuit or a pdemux circuit is shown in FIG. 5A. The CMOS AND gate 500A comprises a CMOS NAND gate attached to an inverter. The CMOS AND gate 500A comprises a first input 502, a second input 504, output 506, and six transistors, which are labeled $Q_1, Q_2, Q_3, Q_4, Q_5, Q_6$.

An example CMOS implementation of an inverter circuit 500B that can be used as the circuit 410 in a demux circuit is shown in FIG. 5B. The inverter circuit 500B comprises pMOS transistor 512 and nMOS transistor 514 which share a common drain terminal 516 and gate terminal 518. The device is powered by applying a voltage difference $V_{dd}$ - $V_{ss}$ between the source terminal 520 and the source terminal 522.

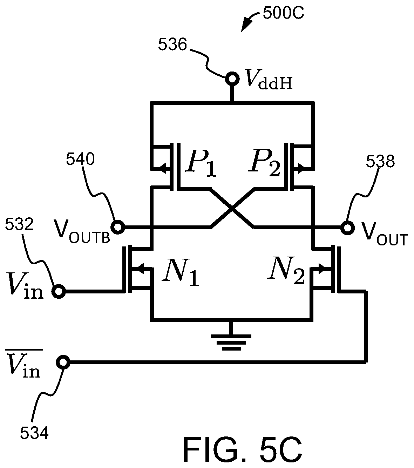

Referring back to FIG. 4B, some circuit modules can comprise a level-shifter circuit connected to the outputs of a metastable circuit. In some examples, a level-shifter circuit can be configured to translate input voltages by adding a reference voltage to the input voltages. An example circuit 500C that can be used as a level-shifter circuit is shown in FIG. 5C. In some examples, the circuit 500C can be used as the level-shifter circuit 432 in circuit 400B. The circuit 500C comprises input port 532 associated with an input voltage $V_{in}$, input port 534 associated with an input voltage $\overline{V_{in}}$, and terminal 536 associated with a voltage $V_{ddH}$. The circuit 500C comprises two cross-coupled nMOS driver transistors $(N_1, N_2)$ and two pMOS latches $(P_1, P_2)$. The output node 538 and the output node 540 are each associated with voltages $V_{OUT}$ and $V_{OUTB}$ respectively. When the voltages $V_{in}$ and $\overline{V_{in}}$ are low and high, $N_1$ is off and $N_2$ is on. $N_2$ then pulls down $V_{OUT}$, causing $P_1$ to turn on which in turn results in $V_{OUTB}$ increasing to $V_{ddh}$ which also causes $P_2$ to turn off. When $P_2$ is off, $V_{OUT}$ drops to ground. The opposite happens when the voltages $V_{in}$ and $\overline{V_{in}}$ are high and low, resulting in $V_{OUT}$ being at the voltage $V_{ddh}$.

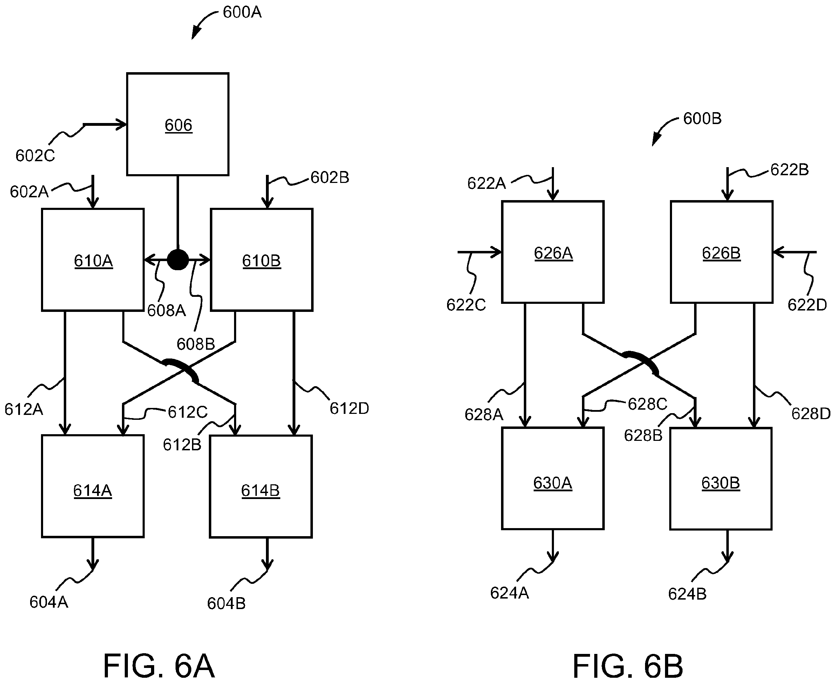

An example probabilistic circuit module 600A is depicted in FIG. 6A. The probabilistic circuit module 600A comprises a first input 602A, a second input 602B, a third input 602C, a first output 604A, and a second output 604B. The probabilistic circuit module 600A comprises a metastable circuit 606 that is configured to receive a bias voltage from the third input 602C and produce, based at least in part on the bias voltage, a first bistable state that varies over time between a first stable voltage and a second stable voltage, where a fraction of time that the first bistable state spends at the first stable voltage is associated with a first probability. In this example, a signal 608A and a signal 608B that are based at least in part on the first bistable state are directed to other circuit modules. At any given time, the signal 608A is based at least in part on the first stable voltage and the signal 608B is based at least in part on the second stable voltage. A first logical circuit module 610A is configured to receive the signal 608A based at least in part on the first bistable state and a voltage from first input 602A. The first logical circuit module 610A is configured to output a logical combination of the signal 608A based at least in part on the first bistable state and the voltage from the first input 602A to each of a first logical circuit 614A and a second logical circuit 614B. In this example, the first logical circuit module 610A outputs a logical combination 612A to the first logical circuit 614A and a logical combination 612B to a second logical circuit 614B. A second logical circuit module 610B is configured to receive the signal 608B based at least in part on the first bistable state and a voltage from the second input 602B. The second logical circuit 614B is configured to output a logical combination of the signal 608B based at least in part on the first bistable state and the voltage from the second input 602B to each of the first logical circuit 614A and the second logical circuit 614B. In this example, the second logical circuit module 610B outputs a logical combination 612C to the first logical circuit 614A and a logical combination 612D to the second logical circuit 614B. The first logical circuit 614A is configured to output a logical combination of the logical combination 612A received from the first logical circuit module 610A and the logical combination 612C received from the second logical circuit module 610B to the first output 604A. The second logical circuit 614B is configured to output a logical combination of the logical combination 612B received from the first logical circuit module 610A and the logical combination 612D received from the second logical circuit module 610B to the second output 604B.

In some implementations, a probabilistic circuit module 600A can be configured such that each of the first logical circuit 614A and the second logical circuit 614B are OR gates, the first logical circuit module 610A and the second logical circuit module 610B each comprise a demux circuit, and the metastable circuit 606 is the circuit 300B, i.e., a $p$-bit, shown in FIG. 3B. In such implementations, the probabilistic circuit module can be referred to as a symmetric PSWAP circuit. A truth table associated with a symmetric PSWAP circuit can be found in table 1.

Table 1: Truth table for the symmetric PSWAP circuit. The probabilities for transitions 01 → 10 and 10 → 01 cannot be tuned independently because the signal 608A associated with the first bistable state corresponds to the signal 608B associated with the first bistable state.

| AB | XY |
|---|---|
| 00 | 00 |
| 01 | 10 with probability $p$, 01 with probability 1 - $p$ |
| 10 | 01 with probability $p$, 10 with probability 1 - $p$ |
| 11 | 11 |

An example probabilistic circuit module 600B is depicted in FIG. 6B. The probabilistic circuit module 600B comprises a first input 622A, a second input 622B, a third input 622C, a fourth input 622D, a first output 624A, and a second output 624B. The probabilistic circuit module 600B comprises a first circuit 626A and a second circuit 626B. In some implementations, the first circuit 626A can be configured as a pdemux circuit such that the pdemux circuit receives a bias voltage from the third input 622C. In some implementations, the second circuit 626B can be configured as a pdemux circuit such that the pdemux circuit receives a bias voltage from the fourth input 622D. A first logical circuit 630A and a second logical circuit 630B each receive outputs from the first circuit 626A and the second circuit 626B. The first logical circuit 630A receives an output 628A from the first circuit 626A and an output 628C from the second circuit 626B. The second logical circuit 630B receives an output 628B from the first circuit 626A and an output 628D from the second circuit 626B. The first circuit 626A is configured to output a logical combination of the output 628A and the output 628C to the first output 624A. The second circuit 626B is configured to output a logical combination of the output 628B and the output 628D to the second output 624B.

In other words, the probabilistic circuit module 600B can comprise two pdemux circuits such that the probabilistic circuit module 600B comprises a first metastable circuit module, i.e., in the first circuit 626A, and a second metastable circuit module, i.e., in the second circuit 626B. The first metastable circuit module is configured to receive a bias voltage and produce, based at least in part on the bias voltage, a first bistable state that varies over time between a first stable voltage and a second stable voltage, where a fraction of time that the first bistable state spends at the first stable voltage is associated with a first probability. The second metastable circuit module is configured to receive a bias voltage and produce, based at least in part on the bias voltage, a second bistable state that varies over time between a third stable voltage and a fourth stable voltage, where a fraction of time that the second bistable state spends at the third stable voltage is associated with a second probability. In some examples, the first stable voltage and the third stable voltage can be substantially equal, i.e., within 10% of each other. In some examples, the second stable voltage and the fourth stable voltage can be substantially equal, i.e., within 10% of each other. The probabilistic circuit module 600B further comprises a first logical circuit, a second logical circuit, a third logical circuit, a fourth logical circuit, a fifth logical circuit, and a sixth logical circuit. The first circuit 626A comprises a first logical circuit (not shown) that is configured to receive a signal based at least in part on the first bistable state and a voltage from the first input 622A and produce a logical combination of the signal based at least in part on the first bistable state and the voltage from the first input 622A to the fifth logical circuit, i.e., the first logical circuit 630A. The first circuit 626A further comprises a second logical circuit (not shown) that is configured to receive a signal based at least in part on the first bistable state and a voltage from the first input 622A and produce a logical combination of the signal based at least in part on the first bistable state and the voltage from the first input 622A to the sixth logical circuit, i.e., the second logical circuit 630B. The second circuit 626B comprises a third logical circuit (not shown) that is configured to receive a signal based at least in part on the second bistable state and a voltage from the second input 622B and produce a logical combination of the signal based at least in part on the second bistable state and the voltage from the second input 622B to the fifth logical circuit, i.e., the first logical circuit 630A. The second circuit 626B further comprises a fourth logical circuit (not shown) that is configured to receive a signal based at least in part on the second bistable state and a voltage from the second input 622B and produce a logical combination of the signal based at least in part on the second bistable state and the voltage from the second input 622B to the sixth logical circuit, i.e., the second logical circuit 630B.

In some implementations, a probabilistic circuit module 600B can be configured such that each of the first logical circuit 630A and the second logical circuit 630B are OR gates and the first circuit 626A and the second circuit 626B each comprise a pdemux circuit. In such implementations, the probabilistic circuit module can be referred to as a symmetric $p$-jump circuit. A truth table associated with a symmetric $p$-jump circuit can be found in table 2.

Table 2: Truth table for a symmetric $p$-jump circuit. The above probabilities assume that the same bias $b$ is applied to both pdemux circuits. In general both biases can be tuned independently so that the transition 01 → 10 can have a different probability compared to 10 → 01.

| AB | XY |
|---|---|
| 00 | 00 |
| 01 | 10 with probability $p$, 01 with probability 1 - $p$ |
| 10 | 01 with probability $p$, 10 with probability 1 - $p$ |
| 11 | 11 with probability 1 - 2$p$ (1 - $p$), 01 with probability $p$ (1 - $p$), 10 with probability $p$ (1 - $p$) |

As shown in FIGS. 6A and 6B, a symmetric PSWAP circuit uses a single $p$-bit circuit that outputs a single voltage instead of two when used in a pdemux. The symmetric PSWAP circuit also uses demux circuits instead of pdemux circuits. Although the PSWAP circuit has simpler circuit components compared to the symmetric $p$-jump circuit due to the single bias source, the probabilities of hopping processes 01 → 10 and 10 → 01 cannot be tuned independently. PSWAP circuits can be used in settings where having different transition probabilities 01 → 10 and 10 → 01 is not necessary.

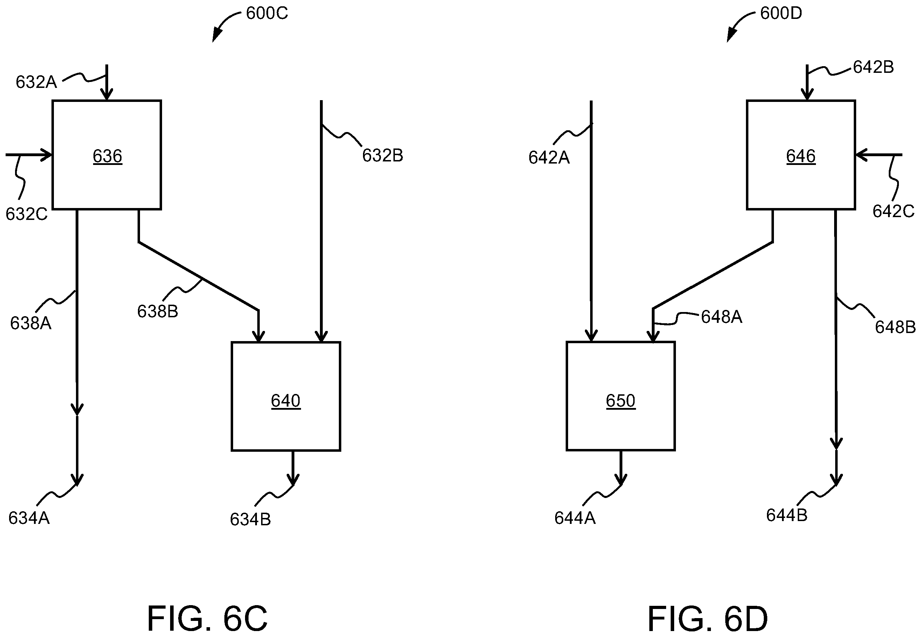

An example probabilistic circuit module 600C is depicted in FIG. 6C. The probabilistic circuit module 600C comprises a first input 632A, a second input 632B, a third input 632C, a first output 634A, and a second output 634B. The probabilistic circuit module 600C comprises a first circuit 636. In some implementations, the first circuit 636 can be configured as a pdemux circuit such that the pdemux circuit receives a bias voltage from the third input 632C. A first logical circuit 640 receives output 638B from the first circuit 636 and outputs a logical combination of the output 638B and the second input 632B to the second output 634B. The first circuit 636 produces an output 638A to the first output 634A.

In some implementations, a probabilistic circuit module 600C can be configured such that the first logical circuit 640 is an OR gate and the first circuit 636 comprises a pdemux circuit. In such implementations, the probabilistic circuit module can be referred to as a left-to-right $p$-jump circuit. A truth table associated with a left-to-right $p$-jump circuit can be found in table 3.

Table 3: Truth table for the left-to-right $p$-jump circuit. When A = 1, the output bit $Y$ is 1 with probability $p$ ($X$ = 0) and 0 with probability 1 - $p$ ($X$ = 1).

| AB | XY |
|---|---|
| 00 | 00 |
| 01 | 01 |
| 10 | 01 with probability $p$, 10 with probability 1 - $p$ |
| 11 | 01 with probability $p$, 11 with probability 1 - $p$ |

An example probabilistic circuit module 600D is depicted in FIG. 6D. The probabilistic circuit module 600D comprises a first input 642A, a second input 642B, a third input 642C, a first output 644A, and a second output 644B. The probabilistic circuit module 600D comprises a first circuit 646. In some implementations, the first circuit 646 can be configured as a pdemux circuit such that the pdemux circuit receives a bias voltage from the third input 642C. A first logical circuit 650 receives output 648A from the first circuit 646 and outputs a logical combination of the output 648A and the first input 642A to the first output 644A. The first circuit 646 produces an output 648B to the second output 644B.

In some implementations, a probabilistic circuit module 600D can be configured such that the first logical circuit 650 is an OR gate and the first circuit 646 comprises a pdemux circuit. In such implementations, the probabilistic circuit module can be referred to as a right-to-left $p$-jump circuit. A truth table associated with a right-to-left $p$-jump circuit can be found in table 4.

Table 4: Truth table for the right-to-left *p*-jump circuit. When *B* = 1, the output bit *X* is 1 with probability *p* (*Y* = 0) and 0 with probability 1 - *p* (*Y* = 1).

| AB | XY |
|----|----|
| 00 | 00 |
| 01 | 10 with probability *p*, 01 with probability 1 - *p* |
| 10 | 10 |
| 11 | 10 with probability *p*, 11 with probability 1 - *p* |

In general, *p*-jump circuits are probabilistic circuits which have two input voltages encoded in binary form and have two output voltages also encoded in binary form. *p*-jump circuits can comprise pdemux circuits and OR gates. By tuning the bias voltages of the pdemux circuits, a *p*-jump circuit generates a hopping process for an input bit 1 with a certain probability.

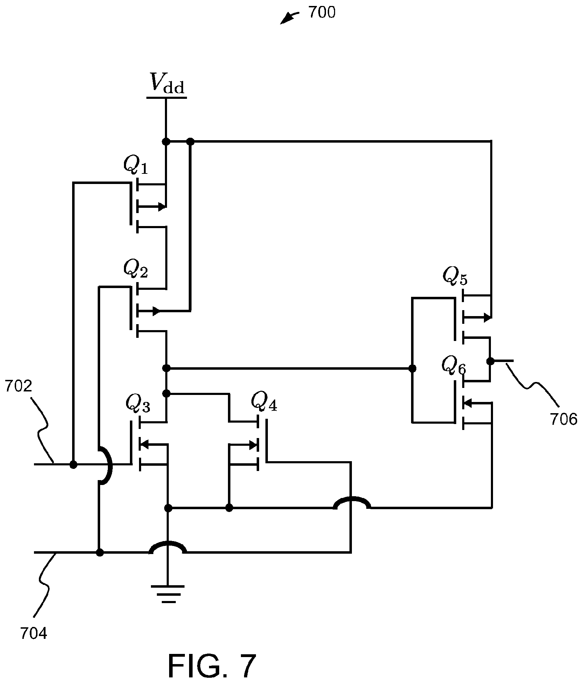

An example circuit 700 is shown in FIG. 7. The circuit 700 is a CMOS implementation of an OR gate. The circuit 700 comprises a first input 702, a second input 704, output 706, and six transistors, which are labeled $Q_1, Q_2, Q_3, Q_4, Q_5, Q_6$.

The transition rates for hopping processes on the graphs can be tuned by tuning the biases applied to the pdemux circuits in a given *p*-jump circuit. The symmetric *p*-jump circuit can generate probabilistic transitions between the two inputs. The transition rates can be tuned by tuning biases of the pdemux circuit. Further, the transition rates can be tuned such that repeated applications of the *p*-jump circuit architecture reaches a steady state generating samples from a programmable Boltzmann distribution, also known as a Gibbs distribution.

Without intending to be bound by theory, the following is an example of a theoretical model for illustrating features. For a p-block circuit having an arbitrary number of input nodes, a forward transition rate $\lambda jk$ is associated with the probability per unit time of the bit 1 hopping from a bit $b_j$ to a neighboring bit $b_k$ for all indices *j* and *k* spanning the input nodes to the p-block circuit. Likewise a reverse transition rate $\lambda kj$ is associated with the probability per unit time of the bit 1 hopping from a bit $b_k$ to a neighboring bit $b_j$ for all indices *j* and *k* spanning the input nodes to the p-block circuit. In some examples, the transition rates $\lambda_{jk}$ and $\lambda_{kj}$ can be related to probabilities of a symmetric PSWAP circuit in table 1. In some examples, the transition rates $\lambda_{jk}$ and $\lambda_{kj}$ can be chosen such that the output to repeated applications of a *p*-block circuit can be sampled from a steady-state distribution. In particular, let *P(t)* denote a vector with the probabilities of observing a particular one-hot encoded vector **b** at time *t*. The continuous time evolution of *P(t)* can be written as:

$$\frac{dP(t)}{dt} = WP(t), \tag{1}$$

where *W* is a matrix of transition rates applied to the vector *P(t)*. Let $P_k(t)$ be the *k*'th component of *P(t)* at time *t*, which corresponds to the probability that $b_k$ is 0 or 1. Performing the matrix multiplication in eq. (1),

$$dP_k(t) = \sum_{j\neq k} \lambda_{kj} P_j(t) dt - \sum_{j\neq k} \lambda_{jk} P_k(t) dt = -J_k(t) dt, \tag{2}$$

where

$$J_k(t) \equiv \sum_{j\neq k} \left( \lambda_{jk} P_k(t) - \lambda_{kj} P_j(t) \right), \tag{3}$$

which represents the net probability flux out of state *k*.

Referring back to FIG. 2B, one application of the circuit 200B can be viewed as a Trotterization step of the solution to eq. (1) which is given by $P(t) = e^{Wt}P(0)$. In particular, let *T* be the total evolution time. The total evolution time *T* can be divided into *M* steps of size $\Delta t$, so that $T = M\Delta t$. Starting from P(0), the solutions to the probability distribution at each of the discretized time intervals is given by

$$P(\Delta t) \approx (I + W\Delta t)P(0)$$

$$P(2\Delta t) \approx (I + W\Delta t)P(\Delta t)$$

$$\vdots$$

$$P(M\Delta t) \approx (I + W\Delta t)P((M-1)\Delta t). \tag{4}$$

One iteration of a *p*-block circuit can implement the transition in eq. (2) which can be viewed as an iteration of a Trotterization step.

Suppose that a goal is to reach a steady state distribution $P^{(ss)}(t)$ which satisfies

$$\frac{dP^{(ss)}(t)}{dt} = 0. \tag{5}$$

Using eq. (2), a steady state solution can satisfy

$$\sum_{j \neq k} \left( \lambda_{kj} P_j^{(ss)} - \lambda_{jk} P_k^{(ss)} \right) = 0. \tag{6}$$

The detailed balance condition requires that, at equilibrium, the probability flux between two states *j* and *k* satisfies

$$\lambda_{kj} P_j^{(ss)} = \lambda_{jk} P_k^{(ss)} \tag{7}$$

for all pairs of states *j* and *k*, which ensures that the net flux between any two states is zero. Assuming that the steady-state distribution follows a Boltzmann distribution

$$P_k^{(ss)} = \frac{e^{-\phi(k)}}{Z}, \tag{8}$$

where *Z* is the partition function, the transition rates may be set as

$$\frac{\lambda_{jk}}{\lambda_{kj}} = e^{-[\phi(j) - \phi(k)]}, \tag{9}$$

since

$$\frac{P_j^{(ss)}}{P_k^{(ss)}} = e^{-[\phi(j) - \phi(k)]}. \tag{10}$$

If the transition rates are chosen to satisfy eq. (9), applying multiple iterations of a *p*-block circuit can eventually result in a steady state distribution which corresponds to a Boltzmann distribution.

During the implementation of a *p*-block circuit, processes can introduce errors, i.e. bit flips, in an output one-hot encoded vector. A primary source of error can be the sampling step performed at the end of the *p*-block circuit, where measurements may be performed during a transition event in the voltage signal, leading to the wrong bit. Some *p*-block circuits can be configured to implement an error detection protocol for detecting bit-flip errors.

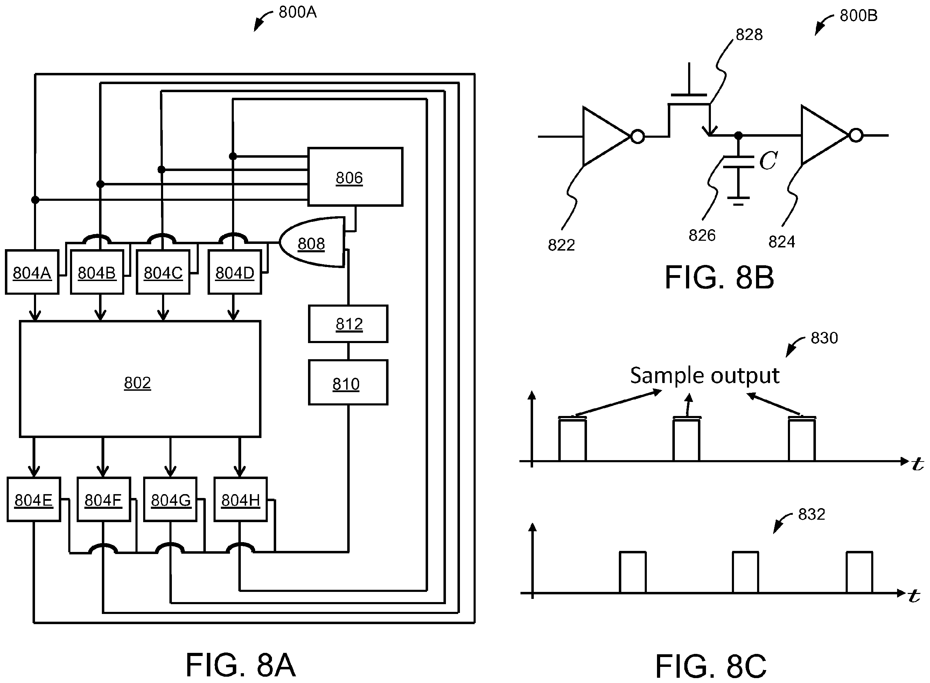

An example circuit 800A that can implement an error detection protocol is shown in FIG. 8A. In other words, the circuit 800A is configured as error detection circuitry. The circuit 800A comprises a *p*-block circuit 802 comprising a plurality of input nodes and a plurality of output nodes. Some error detection circuitry can comprise sample and hold (SH) circuits. The circuit 800A further comprises a plurality of SH circuits 804A-804H, i.e., an SH circuit 804A, an SH circuit 804B, an SH circuit 804C, an SH circuit 804D, an SH circuit 804E, an SH circuit 804F, an SH circuit 804G, and an SH circuit 804H. The SH circuits 804A-804D of the plurality of SH circuits 804A-804H are each connected to a respective input node of the *p*-block circuit 802. The SH circuits 804E-804H of the plurality of SH circuits 804A-804H are each connected to a respective output node of the *p*-block circuit 802. The voltages in the circuit 800A move in a clockwise direction. The SH circuits 804E-804H of the plurality of SH circuits 804A-804H are used to sample the outputs of the *p*-block circuit 802. The circuit 800A also comprises an error detection circuit 806 that is configured to verify if the output of the *p*-block circuit 802 is a one-hot encoded vector. In other words, the error detection circuit 806 is configured to check or confirm that the output is a one-hot encoded vector. If the output is a one-hot encoded vector, the error detection circuit 806 outputs the bit one and otherwise outputs the bit zero. If the output of the error detection circuit 806 is one, the circuitry is configured to send the one-hot encoded vector to the *p*-block circuit 802. If the output of the error detection circuit 806 is zero, the output of the *p*-block circuit 802 is not held and sampled due to the AND gate 808. In such a case, the *p*-block circuit 802 is executed again until a one-hot encoded vector is obtained. In other words, samples are only held if the output of the *p*-block circuit 802 is a one-hot vector. The circuit 800A can also comprise a controller unit 810 and a delay circuit 812. The controller unit 810 ensures that the output of the *p*-block circuit 802 is not sampled and held *during* the execution of the *p*-block circuit 802. Similarly, the delay circuit 812 ensures that the error detection circuit has time to verify whether the output is a one-hot vector or not, and that the SH circuits are applied after the execution of the error detection circuit 806.

An example sample and hold circuit 800B is shown in FIG. 8B. The sample and hold circuit 800B comprises a first inverter 822, a second inverter 824, a capacitor 826 associated with a capacitance *C*, and an nMOS transistor 828. In some examples, the nMOS transistor 828 can be replaced with an active switching element comprising one or both of a pMOS transistor, or a nMOS transistor such that the active switching element is configured to act as a switch based on a respective applied voltage. The nMOS transistor 828 opens and closes to sample an input signal. The capacitor 826 can be used to store a sampled voltage. During the sampling phase, the nMOS transistor 828 is closed thus connecting the input signal to the capacitor 826. The capacitor 826 can then charge to the input voltage. In this phase, the first inverter 822 can receive the input signal and provide an output that is the logical inversion of the input. During the hold phase, the switch is open thus isolating the capacitor 826 from the input. The capacitor 826 can hold the sampled voltage and the second inverter 824 can maintain the inversion of the held voltage, thus providing a stable output that is the inverted value of the voltage stored in the capacitor 826.

In some implementations, external circuitry, such as the readout circuitry shown in FIGS. 8A-8B, can be configured to interact with a circuit architecture or a circuit, or portions thereof. For instance, some external circuitry can interact with a circuit architecture by applying voltages to or reading voltages from a circuit architecture or portions thereof. For instance, control circuitry can be configured to apply control signals or generate voltages to be applied to a circuit. In some examples, readout circuitry configured to read, sample, and/or store voltages from a circuit. In some implementations, circuitry configured to apply control signals to a circuit architecture, or portions thereof, can be positioned on a separate integrated circuit chip or device as the circuit architecture. In some examples, control signals applied to a circuit or signals produced by a circuit can be weak. In some implementations, to mitigate weak signals, circuitry configured to apply control signals to a circuit architecture, or portions thereof, can be positioned in proximity to the circuit architecture, i.e., on the same integrated circuit chip or device that comprises the circuit architecture. In some implementations, circuitry configured to readout signals from a circuit architecture, or portions thereof, can be positioned in proximity to the circuit architecture, i.e., on the same integrated circuit chip or device that comprises the circuit architecture. Positioning one or both of the readout circuitry or the control circuitry in proximity to a circuit architecture can be useful to mitigate losses associated with transmitting weak signals over larger distances.

An example timing protocol 830 associated with the controller unit 810 and an example timing protocol 832 associated with the delay circuit 812 are shown in FIG. 8C.

An example error detection algorithm associated with the circuit 800A is summarized in algorithm 1. In some implementations, all the measured samples can be stored since the error detection circuit 806 ensures that samples which are not one-hot are not stored.

---

**Algorithm 1:** Bit-flip error detection protocol

---

1 Initialize input voltages $b$ which form the input to the circuit 800A.
2 **repeat**
3      Execute the circuit 800A.
4      Store all measured samples from the Store and Hold circuits 804A-804D.
5 **until**;
6 Use the measured samples to form the samples from the random walk algorithm.

---

Some *p*-block circuit modules can be configured to perform a random walk on some arbitrary graph *G*. In some examples, configuring a *p*-block circuit module can comprise an edge-coloring procedure, i.e., a method, in which each edge incident to a given vertex is assigned a different respective color. In general, for a graph comprising a plurality of vertices interconnected by a plurality of nodes, the vertices represent the state of the one-hot input vector and the edges correspond to the allowed transitions of a bit 1 to a bit 0. For instance, if an edge $e_{jk}$ is incident to vertices $v_j$ and $v_k$, transitions from bits $b_j = 1$ and $b_k = 0$ to $b_j = 0$ and $b_k = 1$ in the associated one-hot vector are allowed. Similarly, transitions from bits $b_j = 0$ and $b_k = 1$ to $b_j = 1$ and $b_k = 0$ in the associated one-hot vector are allowed. Configuring a circuit comprising probabilistic circuit modules which implements a random walk on a graph can comprise maximizing a number of symmetric *p*-jump circuits that are implemented in parallel. An edge-coloring algorithm of the graph can maximize the number of symmetric *p*-jump circuits that are implemented in parallel.

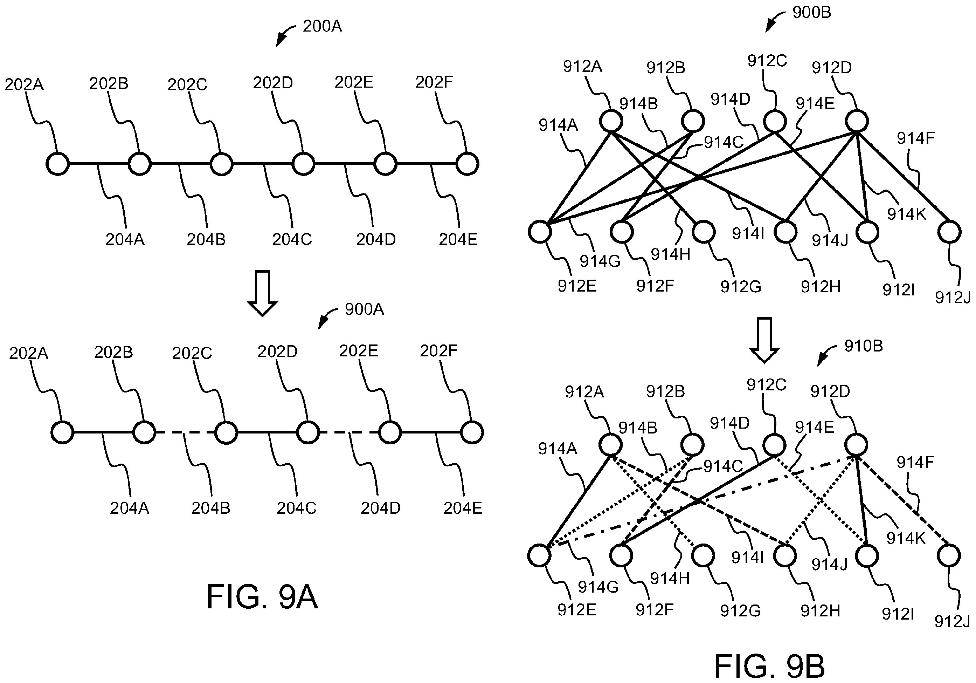

An example procedure for configuring a circuit for the example graph 200A comprising a plurality of vertices 202A-202F interconnected by a plurality of edges 204A-204E is depicted in FIG. 9A. For the graph 200A, transitions are allowed between nearest neighbor vertices along the edges 204A-204E. FIG. 9A depicts a example graph 900A that is the graph 200A with the plurality of edges 204A-204E colored. Each edge of the plurality of edges 204A-204E connected to a respective vertex of the plurality of vertices 202A-202F is colored a different respective color. In this example, the different edge colorings are represented by solid or dashed black and white lines. Since edges have a direct mapping to a symmetric *p*-jump circuit, *p*-jump circuits corresponding to edges of the same color can be implemented in parallel. As shown in the example graph 900A, the edges of the plurality of edges 204A-204E of the graph 200A are two-colorable. Therefore, the *p*-jump circuits for executing all desired transitions can be implemented in two steps, as is shown by the two-level configuration of the circuit 200B shown in FIG. 2B that is configured to generate a random walk of the graph 200A.

This procedure can be extended to more complex graphs. An edge-coloring algorithm can be applied to the graph *G* to find an optimal scheduling of probabilistic circuit modules. A chromatic index of *G* can be defined and denoted $\chi'(G)$, such that the chromatic index of the graph corresponds to the minimum number of colors needed to color the graph *G*. In general, determining whether a given graph is edge-colored with *k* colors can be NP-complete for $k \geq 3$. Therefore, finding an optimal edge coloring or deciding if an edge coloring with *k* colors exists can be computationally intractable for large graphs unless P = NP. For bipartite graphs, the edge coloring problem can be solved in polynomial time. In particular, some algorithms can find an edge coloring in $O(|E|\log|V|)$ time. The chromatic index for a bipartite graph can be exactly $\Delta(G)$, where $\Delta(G)$ is the maximum degree of the graph.

An example of graph 900B is shown in FIG. 9B. The graph 900B can be referred to as a "bipartite graph." The graph 900B comprises a plurality of vertices 912A-912J interconnected by a plurality of edges 914A-914K. FIG. 9B also depicts an example graph 910B that is the graph 900B with the plurality of edges 914A-914K colored. Each edge of the plurality of edges 914A-914K connected to a respective vertex of the plurality of vertices 912A-912J is colored a different respective color, as represented by solid or dashed black and white lines. The graph 900B is four-colorable such that a *p*-block circuit module comprise symmetric *p*-jump circuits that are implemented in four steps.

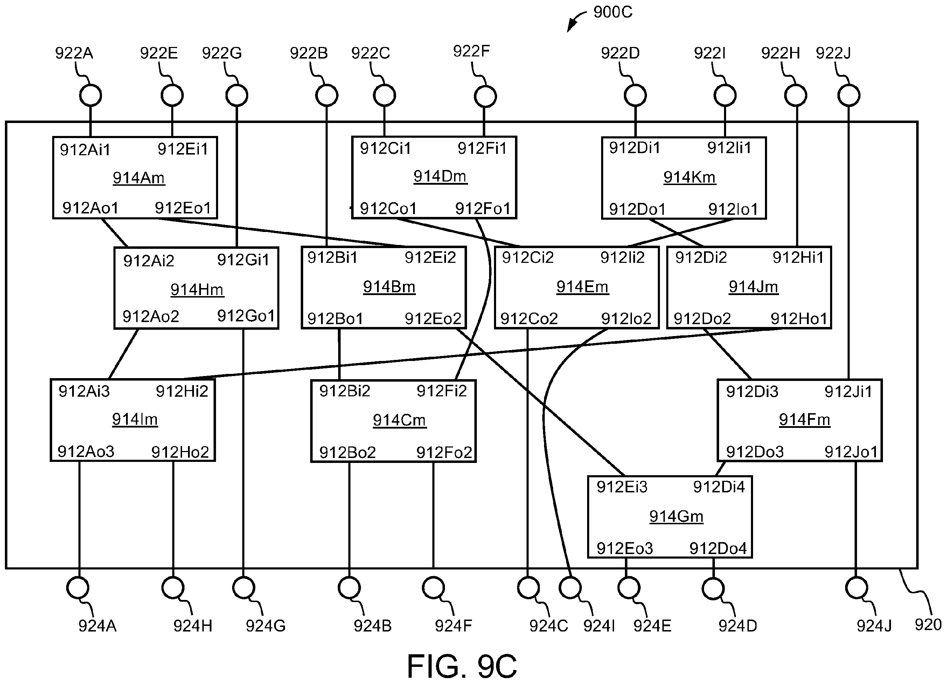

FIG. 9C depicts an example circuit 900C that can generate random walks of the graph 900B. The circuit 900C comprises a *p*-block circuit module 920. The *p*-block circuit module 920 comprises a plurality of input nodes 922A-922J and a plurality of output nodes 924A-924J. Each input node of the plurality of input nodes 922A-922J and each output node of the plurality of output nodes 924A-924J correspond to a different respective vertex of the plurality of vertices 912A-912J of the graph 900B. The *p*-block circuit module 920 comprises a plurality of probabilistic circuit modules 914Am-914Km, where each probabilistic circuit module of the plurality of probabilistic circuit modules 914Am-914Km is associated with a different respective edge of the plurality of edges 914A-914K of the graph 900B. Each probabilistic circuit module of the plurality of probabilistic circuit modules 914Am-914Km comprises a first input, a second input, a first output, and a second output. Each of the first input and the second input and each of the first output and the second output of a respective probabilistic circuit module of the plurality of probabilistic circuit modules 914Am-914Km that is associated with a particular edge of the plurality of edges 914A-914K is associated with a different respective vertex of the plurality of vertices 912A-912J of the graph 900A connected to the particular edge of the plurality of edges 914A-914K. The inputs of each probabilistic circuit module of the plurality of probabilistic circuit modules 914Am-914Km are labeled 912Xij, where each X represents the letter of the vertex of the plurality of vertices 912A-912J with which the input is associated and j is a count of the number of associated inputs. The outputs of each probabilistic circuit module of the plurality of probabilistic circuit modules 914Am-914Km are labeled 912Xok, where each X represents the letter of the vertex of the plurality of vertices 912A-912J with which the output is associated and k is a count of the number of associated outputs. Each input 912Xij associated with a respective vertex of the plurality of vertices 912A-912J is connected to a respective input node of the plurality of input nodes 922A-922J or to an output 912Xok. Each output 912Xok associated with the respective vertex of the plurality of vertices 912A-912J is connected to a respective output node of the plurality of output nodes 924A-924J or to an input 912Xij. In the example *p*-block circuit module 920, the plurality of probabilistic circuit modules 914Am-914Km is implemented in four steps, which corresponds to the four colors of the graph 910B. The input vector *b* to the *p*-block circuit module 920 is a one-hot encoded vector of length ten and the allowed transitions between bits are shown by the edges.

An example protocol, i.e., a method, for constructing *p*-jump circuits given a graph *G* is summarized in algorithm 2.

| **Algorithm 2:** Creating a $p$-block circuit for general graph $G$ |
| --- |
| **1 Inputs:** One-hot encoded vector $\boldsymbol{b}$ of length $N$. Graph $G$ where an edge $e_{jk}$ incident to vertices $v_j$ and $v_k$ describes an allowed transition of the bit 1 between bits $b_j$ and $b_k$. <br> **2** Implement an edge coloring algorithm to find the minimum number of colored edges for the graph. <br><br> **3** Add a probabilistic circuit module for each edge $\left\{ e_1^{(c)}, \cdots, e_k^{(c)} \right\}$ for a given color $c$. All such probabilistic circuit modules can be implemented in parallel. <br> **4** Repeat **step 3** for each color. <br> **5** Connect the inputs of each probabilistic circuit module of a given color to the corresponding outputs of probabilistic circuit modules of a different color or to the corresponding input nodes of the $p$-block circuit. <br> **6** Connect the remaining unconnected outputs of each probabilistic circuit module of a given color to the corresponding inputs of probabilistic circuit modules of a different color or to the corresponding output nodes of the $p$-block circuit. |

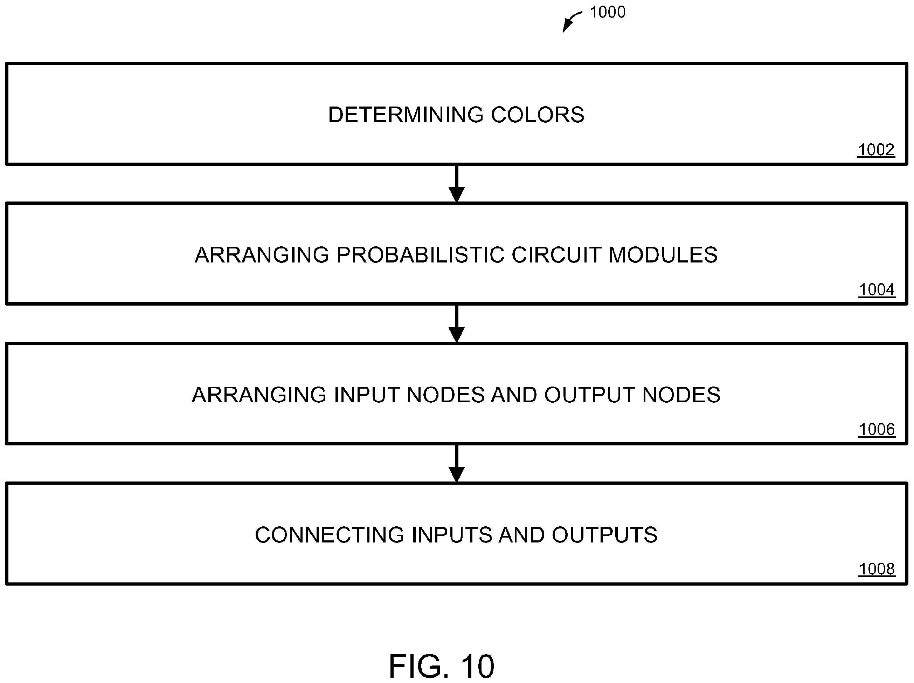

In other words, circuits can be configured according to a method such that the circuit can generate random walks on a graph comprising a plurality of vertices interconnected by a plurality of edges such that each vertex of the plurality of vertices is connected to one or more other vertices of the plurality of vertices by different respective edges of the plurality of edges. FIG. 10 depicts a flowchart of an example method 1000 of configuring a circuit. The method 1000 comprises determining 1002 a number of colors associated with the graph, wherein each vertex of the plurality of vertices is connected to respective edges of the plurality of edges such that the respective edges of the plurality of edges are each associated with a different respective color. The method 1000 further comprises arranging 1004 a plurality of probabilistic circuit modules, wherein each probabilistic circuit module of the plurality of probabilistic circuit modules comprises a first input, a second input, a first output, and a second output, and each probabilistic circuit module of the plurality of probabilistic circuit modules is associated with a different respective edge of the plurality of edges. The method 1000 further comprises arranging 1006 a plurality of input nodes and a plurality of output nodes. The method 1000 further comprises connecting 1008 inputs and outputs. In some implementations, the connecting 1008 can comprise connecting each output of each probabilistic circuit module of the plurality of probabilistic circuit modules that is associated with a first color to a different respective output node of the plurality of output nodes. The connecting 1008 can further comprise connecting each input of each probabilistic circuit module of the plurality of probabilistic circuit modules that is associated with a second color to a different respective input node of the plurality of input nodes. The connecting 1008 can further comprise connecting each output of each probabilistic circuit module of the plurality of probabilistic circuit modules to a different respective input of a different probabilistic circuit module of the plurality of probabilistic circuit modules or to a different respective output node of the plurality of output nodes such that the outputs of each probabilistic circuit module of the plurality of probabilistic circuit modules associated with a respective color are each connected to different respective inputs of each probabilistic circuit module of the plurality of probabilistic circuit modules associated with a different color or to an output node of the plurality of output nodes.

Given a circuit construction comprising probabilistic circuit modules, or $p$-jump modules, a steady state distribution can be generated. In other words, given the output of a circuit composed of $p$-jump modules implementing a random walk on some graph $G$, the output of the circuit is used as a new input and such a process is repeated until the outputs are sampled from a steady state distribution. However to reach a steady state, the transition rates between vertices are tuned to satisfy the condition in eq. (9). Note that the transition rates $\lambda_{jk}$ between vertices $v_j$ and $v_k$ can be tuned by choosing the appropriate biases in the pdemux circuits used in the p-jump modules. The matrix $W$ in eq. (1) depends on the graph topology $G$ (see the decomposition leading to eq. (2)) as well as the biases used in the pdemux circuits. An error detection protocol such as the example provided in algorithm 1 can be used to detect bit-flip errors which may occur during the implementation of circuits.

In some implementations, a circuit architecture can be formed as part of a system. A system can be implemented in various configurations, including as a single apparatus or as a combination of one or more apparatuses that collectively perform the functions of a system. In some examples, the one or more apparatuses can form a device, i.e., a system-on-a-chip, or the one or more apparatuses can be separate devices.

In some implementations, a system can be formed from one or more integrated circuit (IC) chips comprising portions of a circuit architecture. Some circuit architectures can be distributed across multiple chips or consolidated onto a single chip. Some chips can comprise multiple layers of material. In some examples, portions of a circuit architecture can be formed across several layers of devices.

Some systems can comprise analog, digital, or mixed-signal circuitry configured to perform functions such as signal processing, voltage regulation, or data acquisition. Some systems can comprise interface or control circuitry configured to perform functions such as applying bias voltages, measuring voltages, or interfacing with components of the circuit. In some examples, control circuitry can be implemented in one or more dedicated regions of an IC, or distributed throughout a circuit architecture. In some examples, control circuitry can comprise components such as a field-programmable gate array (FPGA), an application specific integrated circuit (ASIC), one or more processors or processor cores, including central processing unit(s) (CPU(s)) and/or graphics processing unit(s) (GPU(s)), or other computing devices or modules capable of executing a program (e.g., software and/or firmware) comprising instructions or other compiled or executable code. The electronic circuitry can also include at least one data storage system (e.g., including volatile and non-volatile memory, and/or storage media). The program may be provided on a computer-readable storage medium, or delivered over a communication medium such as a wired or wireless network, to a device module where it can be stored and eventually executed when read by the device to perform the procedures of the program.

In some implementations, portions of a circuit architecture and control circuitry can be arranged in a flip-chip configuration to allow for three-dimensional integration of multiple chips or substrates. Some flip-chip configurations comprise conductive structure such as wire bonds, microbumps, or vias to facilitate electrical communication between multiple layers or chips.

While the disclosure has been described in connection with certain embodiments, it is to be understood that the disclosure is not to be limited to the disclosed embodiments but, on the contrary, is intended to cover various modifications and equivalent arrangements included within the scope of the appended claims, which scope is to be accorded the broadest interpretation so as to encompass all such modifications and equivalent structures as is permitted under the law.

**Claims**

1. An apparatus for generating random walks on a graph comprising a plurality of vertices interconnected by a plurality of edges such that each vertex of the plurality of vertices is connected to one or more other vertices of the plurality of vertices by different respective edges of the plurality of edges, the apparatus comprising:

   a circuit module comprising

      a plurality of input nodes where each input node of the plurality of input nodes is associated with a respective voltage input value such that the plurality of input nodes is associated with a vector of voltage input values, a plurality of output nodes where each output node of the plurality of output nodes is associated with a respective voltage output value such that the plurality of output nodes is associated with a vector of voltage output values, and
      mapping circuitry defining a different respective mapping from each input node of the plurality of input nodes to a respective output node of the plurality of output nodes; and

   error detection circuitry connected to each output node of the plurality of output nodes;
   wherein each vertex of the plurality of vertices of the graph is associated with a different respective input node of the plurality of input nodes and the respective voltage input value in the vector of voltage input values by a respective index and each vertex of the plurality of vertices of the graph is associated with a different respective output node of the plurality of output nodes and a voltage output value in the vector of output voltage values by a respective index;
   wherein each edge of the plurality of edges of the graph is associated with a different respective mapping defined by the mapping circuitry;
   wherein the circuit module is configured to receive the vector of voltage input values where one voltage input value in the vector of voltage input values is a first voltage value having a first index with respect to one input node of the plurality of input nodes, and each other voltage input value in the vector of voltage input values is a second voltage value different from the first voltage value;
   wherein the circuit module is configured to produce, based at least in part on the vector of voltage input values and the mapping circuitry, the vector of voltage output values where one voltage output value in the vector of voltage output values is the first voltage value having a second index with respect to one output node in the plurality of output nodes; and
   wherein the error detection circuitry is configured to confirm that one voltage output value in the vector of voltage output values is the first voltage value and each other voltage output value in the vector of voltage output values is the second voltage value.

2. The apparatus of claim 1, wherein upon confirming that one voltage output value in the vector of voltage output values is the first voltage value and each other voltage output value in the vector of voltage output values is the second voltage value, the error detection circuitry is configured to send the vector of voltage output values to the plurality of input nodes.

3. The apparatus of claim 1 or 2, wherein the mapping circuitry comprises a plurality of probabilistic circuit modules, each probabilistic circuit module of the plurality of probabilistic circuit modules comprising

a first input,
a second input,
a first output, and
a second output,
wherein each probabilistic circuit module of the plurality of probabilistic circuit modules is associated with a different respective edge of the plurality of edges of the graph and each of the first input and the second input and each of the first output and the second output of a respective probabilistic circuit module of the plurality of probabilistic circuit modules associated with a particular edge of the plurality of edges is associated with a different respective vertex of the plurality of vertices of the graph connected to the particular edge of the plurality of edges, wherein each probabilistic circuit module input associated with a respective vertex of the plurality of vertices of the graph is connected to a respective input node of the plurality of input nodes associated with the respective vertex of the plurality of vertices of the graph or to a probabilistic circuit module output associated with the respective vertex of the plurality of vertices of the graph, and
wherein each probabilistic circuit module output associated with a respective vertex of the plurality of vertices of the graph is connected to a respective output node of the plurality of output nodes associated with the respective vertex of the plurality of vertices of the graph or to a probabilistic circuit module input associated with the respective vertex of the plurality of vertices of the graph.

4. The apparatus of claim 3, wherein each probabilistic circuit module of plurality of probabilistic circuit modules further comprises a third input and a first metastable circuit module configured to receive a bias voltage from the third input and produce, based at least in part on the bias voltage, a first bistable state that varies over time between a first stable voltage and a second stable voltage, where a fraction of time that the first bistable state spends at the first stable voltage is associated with a first probability.

5. The apparatus of claim 4, wherein each probabilistic circuit module of the plurality of probabilistic circuit modules further comprises a level-shifter circuit configured to add a voltage to or subtract a voltage from a signal based at least in part on the first stable voltage and a signal based at least in part on the second stable voltage.

6. The apparatus of claim 4, wherein one or more probabilistic circuit modules of the plurality of probabilistic circuit modules further comprises a first logical circuit, a second logical circuit, a third logical circuit, wherein

the first logical circuit is configured to receive a signal based at least in part on the first bistable state and a voltage from the first input and output a logical combination of the signal based at least in part on the first bistable state and the voltage from the first input to the third logical circuit,
the second logical circuit is configured to receive a signal based at least in part on the first bistable state and a voltage from the first input and output a logical combination of the signal based at least in part on the first bistable state and the voltage from the first input to the second output, and
the third logical circuit is configured to receive a voltage from the second input and output a logical combination of the logical combination received from the first logical circuit and the voltage from the second input to the first output.

7. The apparatus of claim 6, wherein each of the first logical circuit and the second logical circuit comprise respective AND gates and the third logical circuit comprises an OR gate.

8. The apparatus of claim 4, wherein one or more probabilistic circuit modules of the plurality of probabilistic circuit modules further comprises a first logical circuit module, a second logical circuit module, a first logical circuit, and a second logical circuit, wherein

the first logical circuit module is configured to receive a signal based at least in part on the first bistable state and a voltage from first input and output a logical combination of the signal based at least in part on the first bistable state and the voltage from the first input to each of the first logical circuit and the second logical circuit,

the second logical circuit module is configured to receive a signal based at least in part on the first bistable state and a voltage from the second input and output a logical combination of the signal based at least in part on the first bistable state and the voltage from the second input to each of the first logical circuit and the second logical circuit, the first logical circuit is configured to output a logical combination from the first logical circuit module and the second logical circuit module to the first output, and

the second logical circuit is configured to output a logical combination from the first logical circuit module and the second logical circuit module to the second output.

9. The apparatus of claim 8, wherein each of the first logical circuit and the second logical circuit comprise respective OR gates, and each of the first logical circuit module and the second logical circuit module comprise a respective first AND gate, a second AND gate, and an inverter.

10. The apparatus of claim 4, wherein one or more probabilistic circuit modules of the plurality of probabilistic circuit modules further comprises a fourth input and a second metastable circuit module configured to receive a bias voltage from the fourth input and produce, based at least in part on the bias voltage, a second bistable state that varies over time between a third stable voltage and a fourth stable voltage, where a fraction of time that the second bistable state spends at the third stable voltage is associated with a second probability.

11. The apparatus of claim 10, wherein the one or more probabilistic circuit modules further comprises a first level-shifter circuit and a second level-shifter circuit wherein the first level-shifter circuit is configured to shift a signal based at least in part on the first bistable state produced by the first metastable circuit module and the second level-shifter circuit is configured to shift a signal based at least in part on the second bistable state produced by the second metastable circuit module.

12. The apparatus of claim 11, wherein the first level-shifter circuit is configured to add a reference voltage to or subtract a reference voltage from each of the first stable voltage and the second stable voltage and the second level-shifter circuit is configured to add a reference voltage to or subtract a reference voltage from each of the third stable voltage and the fourth stable voltage.

13. The apparatus of claim 10, wherein

the first stable voltage and the third stable voltage of each probabilistic circuit module of the plurality of probabilistic circuit modules are equal, and

the second stable voltage and the fourth stable voltage of each probabilistic circuit module of the plurality of probabilistic circuit modules are equal.

14. The apparatus of claim 10, wherein the one or more probabilistic circuit modules of the plurality of probabilistic circuit modules further comprise a first logical circuit, a second logical circuit, a third logical circuit, a fourth logical circuit, a fifth logical circuit, and a sixth logical circuit, wherein

the first logical circuit is configured to receive a signal based at least in part on the first bistable state and a voltage from the first input and produce a logical combination of the signal based at least in part on the first bistable state and the voltage from the first input to the fifth logical circuit,

the second logical circuit is configured to receive a signal based at least in part on the first bistable state and a voltage from the first input and produce a logical combination of the signal based at least in part on the first bistable state and the voltage from the first input to the sixth logical circuit,

the third logical circuit is configured to receive a signal based at least in part on the second bistable state and a voltage from the second input and produce a logical combination of the signal based at least in part on the second bistable state and the voltage from the second input to the fifth logical circuit,

the fourth logical circuit is configured to receive a signal based at least in part on the second bistable state and a voltage from the second input and produce a logical combination of the signal based at least in part on the second bistable state and the voltage from the second input to the sixth logical circuit,

the fifth logical circuit is configured to produce a logical combination of the logical combination received from the first logical circuit and the logical combination received from the third logical circuit to the first output, and

the sixth logical circuit is configured to produce a logical combination of the logical combination received from the second logical circuit and the logical combination received from the fourth logical circuit to the second output.

15. The apparatus of claim 14, wherein each of the first logical circuit, the second logical circuit, the third logical circuit, and the fourth logical circuit comprise a respective AND gate, and each of the fifth logical circuit and the sixth logical circuit comprise a respective OR gate.

EP 4 711 914 A1

108 [ 0 1 0 0 ... 0 ]

100

104A 104B 104C 104D 104N

...

102

...

106A 106B 106C 106D 106N

110 [ 0 0 1 0 ... 0 ]

FIG. 1

FIG. 2A

FIG. 2C

FIG. 2B

EP 4 711 914 A1

FIG. 2D

FIG. 2E

FIG. 2F

FIG. 2G

EP 4 711 914 A1

FIG. 3A

EP 4 711 914 A1

FIG. 3B

300C

$V_{out}^1$ 326

$V_{out}^2$ 328

N-Level shifter

P-Level shifter

$V_b^p$ 330

Single-ended to diff converter

$V_b^n$ 332

Noise generator

$V_{in}^p$ 322

$V_{in}^n$ 324

FIG. 3C

FIG. 3D

EP 4 711 914 A1

FIG. 4A

FIG. 4B

EP 4 711 914 A1

FIG. 5B

FIG. 5A

EP 4 711 914 A1

FIG. 5C

FIG. 6B

FIG. 6A

FIG. 6C

FIG. 6D

EP 4 711 914 A1

FIG. 7

EP 4 711 914 A1

FIG. 8B

FIG. 8C

FIG. 8A

FIG. 9A

FIG. 9B

FIG. 9C

EP 4 711 914 A1

DETERMINING COLORS

1002

ARRANGING PROBABILISTIC CIRCUIT MODULES

1004

ARRANGING INPUT NODES AND OUTPUT NODES

1006

CONNECTING INPUTS AND OUTPUTS

1008

FIG. 10

EP 4 711 914 A1

## EUROPEAN SEARCH REPORT

Application Number

EP 25 20 0842

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2020/342055 A1 (PATRA RHICHEEK [CH] ET AL) 29 October 2020 (2020-10-29) * paragraph [0029] - paragraph [0040]; figure 2 * * paragraph [0066] - paragraph [0088]; figures 7, 8 * | 1-15 | INV. G06F7/58 G06N5/01 |
| A | JAN KAISER ET AL: "Probabilistic computing with p-bits", ARXIV.ORG, CORNELL UNIVERSITY LIBRARY, 201 OLIN LIBRARY CORNELL UNIVERSITY ITHACA, NY 14853, 12 October 2021 (2021-10-12), XP091068785, DOI: 10.1063/5.0067927 * section II, III * | 1-15 | |
| A | US 2020/004902 A1 (AIMONE JAMES BRADLEY [US] ET AL) 2 January 2020 (2020-01-02) * paragraph [0033] - paragraph [0049]; figures 1-3 * | 1-15 | |
| A | SANJUKTA BHANJA ET AL: "A stimulus-free graphical probabilistic switching model for sequential circuits using dynamic bayesian networks", ACM TRANSACTIONS ON DESIGN AUTOMATION OF ELECTRONIC SYSTEMS, ACM, NEW YORK, NY, US, vol. 11, no. 3, 7 June 2004 (2004-06-07), pages 773-796, XP058222508, ISSN: 1084-4309, DOI: 10.1145/1142980.1142990 * section 1.1; figure 1 * | 1-15 | TECHNICAL FIELDS SEARCHED (IPC) G06F G06N |

The present search report has been drawn up for all claims

| Place of search | Date of completion of the search | Examiner |
|---|---|---|
| Munich | 13 January 2026 | Prins, Leendert |

EPO FORM 1503 03.82 (P04C01)

EP 4 711 914 A1

## ANNEX TO THE EUROPEAN SEARCH REPORT
## ON EUROPEAN PATENT APPLICATION NO.

EP 25 20 0842

This annex lists the patent family members relating to the patent documents cited in the above-mentioned European search report.
The members are as contained in the European Patent Office EDP file on
The European Patent Office is in no way liable for these particulars which are merely given for the purpose of information.

13-01-2026

| Patent document cited in search report | Publication date | Patent family member(s) | Publication date |
|---|---|---|---|
| US 2020342055 A1 | 29-10-2020 | US 2020342055 A1<br>US 2021142008 A1 | 29-10-2020<br>13-05-2021 |
| US 2020004902 A1 | 02-01-2020 | NONE | |

EPO FORM P0459

For more details about this annex : see Official Journal of the European Patent Office, No. 12/82

**EP 4 711 914 A1**

**Patent documents cited in the description**

- US 63694480